# EUROPEAN PATENT APPLICATION

(11) **EP 4 745 969 A1**
(43) Date of publication of application: **20.05.2026**
(21) Application number: 25821162.2
(22) Date of filing: 05.06.2025
(51) Int. Cl.: G11C 11/4076, G11C 11/4078, G11C 11/409

(54) **METHOD FOR OPTIMIZING TRANSMISSION SIGNALS OF MEMORY, AND MEMORY CONTROLLER AND ELECTRONIC DEVICE**

(30) Priority: 11.06.2024 CN 202410750796
(71) Applicant: Hygon Yunxin Integrated Circuit Design (Shanghai) Co., Ltd., Shanghai 201203 (CN)
(72) Inventor: FAN, Minmin, Shanghai 201203 (CN)
(74) Representative: Bergenstråhle & Partners AB
(86) International application number: PCT/CN2025/099242
(87) International publication number: WO 2025/256450

(57) **Abstract**

The present disclosure relates to a method for optimizing a transmission signal of a memory, a memory controller and an electronic device, which belong to the field of electronic technologies. The method includes: adjusting the values of a first DCA register group and generating a DQ data signal based on an optimal value of the adjusted first DCA register group obtained by adjustment, wherein the values of the first DCA register group are related to the phase of a first system clock signal in the memory, and the first system clock signal is used to generate the DQ data signal; and adjusting the values of a second DCA register group based on the optimal value of the first DCA register group obtained by adjustment, and generating a DQS clock signal based on the optimal value of the second DCA register group obtained by adjustment, wherein the values of the second DCA register group are related to the phase of a second system clock signal in the memory, and the second system clock signal is used to generate the DQS clock signal; wherein the DQS clock signal and the DQ data signal are transmission signals between the memory and a memory controller. By improving the quality of the transmission signal of the memory, the read-write reliability of the memory is enhanced.

## Description

### RELATED APPLICATION

The present disclosure claims priority to Chinese invention patent No. 202410750796.6, entitled "method for optimizing transmission signal of memory, memory controller and electronic device", and filed on June 11, 2024, the entire content of which is incorporated herein by reference.

### TECHNICAL FIELD

The present disclosure belongs to the field of electronic technology, and particularly relates to a method for optimizing a transmission signal of a memory, a memory controller, and an electronic device.

### BACKGROUND

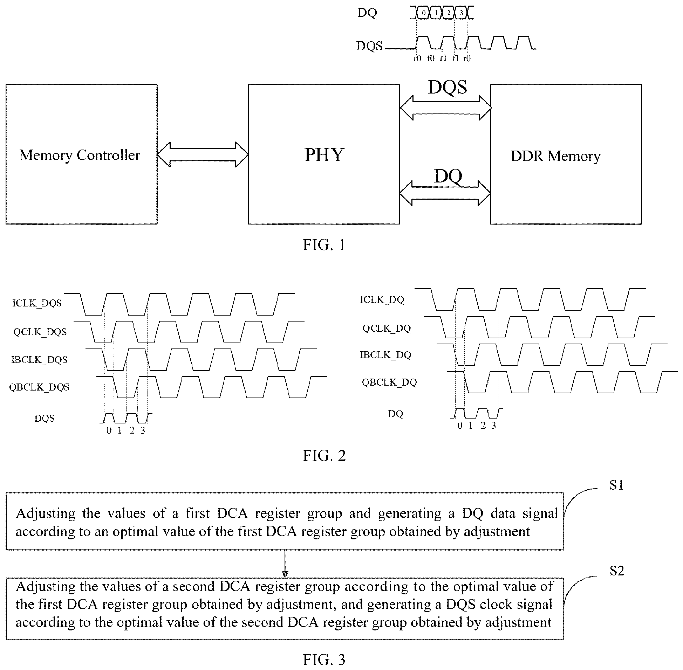

A Double Data Rate Synchronous Dynamic Random Access Memory (DDRSDRAM) is a type of memory in which a data rate is twice a clock rate, which is abbreviated as a DDR memory. As illustrated in FIG. 1, in a DDR system, data signal (DQ) is synchronized with a rising edge and a falling edge of a clock signal DQS, respectively. A memory controller interacts with the DDR memory through a physical layer interface (PHY), and an interface between the PHY and the DDR memory is abbreviated as a DDR interface. The read-write reliability of the DDR interface determines the reliability of the memory controller.

With the increase in the operating frequency of a Central Processing Unit (CPU), the frequency required for the DDR interface is increasingly higher. Higher frequencies tend to cause problems such as a signal duty cycle distortion, clock jitter, etc., and the reduction in the read-write reliability caused by these problems is increasingly significant.

### SUMMARY

In view of this, the present disclosure aims to provide a method for optimizing a transmission signal of a memory, a memory controller and an electronic device, so as to improve the quality of the transmission signal of the memory, thereby enhancing the read-write reliability of the memory.

The embodiments of the present disclosure are implemented as follows.

In a first aspect, an embodiment of the present disclosure provides a method for optimizing a transmission signal of a memory, including: adjusting the values of a first DCA register group and generating a DQ data signal according to an optimal value of the first DCA register group obtained by adjustment, in which the values of the first DCA register group are related to the phase of a first system clock signal in the memory, and the first system clock signal is used to generate the DQ data signal; and adjusting the values of a second DCA register group according to the optimal value of the first DCA register group obtained by adjustment, and generating a DQS clock signal according to the optimal value of the second DCA register group obtained by adjustment, in which the values of the second DCA register group are related to the phase of a second system clock signal in the memory, and the second system clock signal is used to generate the DQS clock signal; and in which the DQS clock signal and the DQ data signal are transmission signals between the memory and a memory controller.

In the above implementation, the DDR5 (5^{th} generation DDR) specification provides a set of registers that can improve the phase relationship of the system clocks, abbreviated as DCA registers. The value of the DCA register is related to the phase of the system clock signal in the DDR memory, and the system clock signal is used to generate the transmission signal of the DDR memory (including the DQS clock signal and the DQ data signal). Therefore, the present disclosure adopts a novel approach: through the adjustment of the value of the DCA register, the change in the value of the DCA register causes the phase of the system clock signal to be changed, and then causes the change in the high-level time and the low-level time of the DQS clock signal and the DQ data signal, which improves the duty cycle distortion and the clock jitter of the transmission signal of the memory, thereby enhancing the read-write reliability of the memory. Moreover, during the adjustment of the values of the DCA registers, the method of first adjusting the values of the first DCA register group through training ensures the training result of the DQ data signal is not affected by the initial duty cycle and the cycle-to-cycle jitter of the DQS clock signal. On the basis of the optimized DQ data signal, the duty cycle and the cycle-to-cycle jitter of the DQS clock signal are then optimized. The entire flow does not require multiple iterations of the mutual optimization between the DQS clock signal and the DQ data signal, nor does it require additional hardware circuits, which reduces the hardware overhead and the training time.

In a possible implementation combined with the embodiment of the first aspect, the first system clock signal includes 2ⁿ-phase clock signals each having an independent DCA register, and n is an integer greater than or equal to 2; the adjusting the values of a first DCA register group includes: adjusting the values of DCA registers corresponding to first-type phase clock signals in the first DCA register group to obtain an optimal value of the DCA registers corresponding to the first-type phase clock signals, in which the first-type phase clock signals are those related to the clock jitter of the DQ data signal; and according to the optimal value of the DCA registers corresponding to the first-type phase clock signals obtained by adjustment, adjusting the values of DCA registers corresponding to second-type phase clock signals in the first DCA register group to obtain an optimal value of the DCA registers corresponding to the second-type phase clock signals, in which the second-type phase clock signals are those related to the duty cycle of the DQ data signal.

In the above implementation, the values of the DCA registers corresponding to the first-type phase clock signals are adjusted firstly to optimize the clock jitter of the DQ data signal, and then the values of the DCA registers corresponding to the second-type phase clock signals are adjusted to optimize the duty cycle distortion of the DQ data signal. This not only achieves the objective but also reduces the adjustment time, so that the training optimization time has a linear relationship with the number of phases of the system clock.

In a possible implementation combined with the embodiment of the first aspect, the first system clock signal includes 2ⁿ-phase clock signals each having an independent DCA register, and n is an integer greater than or equal to 2; the adjusting the values of a first DCA register group includes: adjusting the values of the first DCA register group and generating the DQ data signal according to the adjusted values of the first DCA register group; obtaining 2ⁿ eye widths where correct sampled data is obtained by sampling the DQ data signal using the DQS clock signal, in which each of the eye widths represents a phase difference between a corresponding phase clock signal and a subsequent phase clock signal; and adjusting the values of the first DCA register group according to the 2ⁿ eye widths, so that the 2ⁿ eye widths where correct sampled data is obtained by sampling a new DQ data signal using the DQS clock signal are the same, in which the new DQ data signal is generated according to the adjusted values of the first DCA register group.

In the above implementation, by obtaining 2ⁿ eye widths to adjust the values of the first DCA register group, the 2ⁿ eye widths where correct sampled data is obtained by sampling the new DQ data signal (generated according to the adjusted values of the first DCA register group) using the DQS clock signal are made the same, thereby optimizing the duty cycle of the DQ data signal.

In a possible implementation combined with the embodiment of the first aspect, the adjusting the values of a first DCA register group according to the 2ⁿ eye widths includes: involving n rounds of adjustments of the values of the first DCA register group, in which a first round of adjustment of the values of the first DCA register group includes: according to the first 2ⁿ⁻¹ eye widths and the last 2ⁿ⁻¹ eye widths, adjusting the value of the DCA register for a (2ⁿ⁻¹ + 1)-th phase clock signal in the first DCA register group, so that a sum of the first 2ⁿ⁻¹ eye widths is equal to a sum of the last 2ⁿ⁻¹ eye widths; where i takes values from 2 to n-1 in sequence, an i-th round of adjustment of the values of the first DCA register group includes: generating a new DQ data signal according to an optimal value of the first DCA register group obtained from the (i-1)-th round of adjustment, and obtaining 2ⁿ new eye widths according to the new DQ data signal; adjusting the value of the DCA register for an (m*2ⁿ⁻ⁱ + 1)-th phase clock signal in the first DCA register group according to the 2ⁿ new eye widths, so that each sum of eye widths is the same, and each sum of eye widths is corresponding to a sum of 2ⁿ⁻ⁱ adjacent eye widths, in which m takes odd numbers in a range [1, 2ⁱ) in sequence; an n-th round of adjustment of the values of the first DCA register group includes: generating a new DQ data signal according to the optimal value of the first DCA register group obtained from the (n-1)-th round of adjustment, and obtaining 2ⁿ new eye widths according to the new DQ data signal; adjusting the value of the DCA register for a (k + 1)-th phase clock signal in the first DCA register group according to the 2ⁿ new eye widths, so that each eye width is the same, in which k takes odd numbers in a range [1, 2ⁿ) in sequence.

In the above implementation, through the n rounds of adjustments of the values of the first DCA register group, the duty cycle of the DQ data signal can be optimized. The above method can be applied to the DQS clock signals and the DQ data signals generated by a 2ⁿ-phase system clock, which greatly expands the application scenarios of the present disclosure.

In a possible implementation combined with the embodiment of the first aspect, the first system clock signal includes 2ⁿ-phase clock signals each having an independent DCA register, and n is an integer greater than or equal to 2; the adjusting the values of a first DCA register group includes: involving n rounds of adjustments of the values of the first DCA register group, in which a first round of adjustment of the values of the first DCA register group includes: adjusting the values of the DCA register for a (2ⁿ⁻¹ + 1)-th phase clock signal in the first DCA register group according to a first eye width and a second eye width, so that an eye width corresponding to the first 2ⁿ⁻¹ phase clock signals is equal to an eye width corresponding to the last 2ⁿ⁻¹ phase clock signals, in which the first eye width is an eye width corresponding to the first 2ⁿ⁻¹ phase clock signals, the second eye width is an eye width corresponding to the last 2ⁿ⁻¹ phase clock signals, and each eye width represents a phase difference between a corresponding phase clock signal and a subsequent phase clock signal; where i takes values from 2 to n-1 in sequence, an i-th round of adjustment of the values of the first DCA register group includes: generating a new DQ data signal according to the optimal value of the first DCA register group obtained from the (i-1)-th round of adjustment, and obtaining 2ⁱ eye widths according to the new DQ data signal, in which each eye width is a sum of the eye widths corresponding to adjacent 2ⁿ⁻ⁱ phase clock signals; and adjusting the value of the DCA register for an (m*2ⁿ⁻ⁱ + 1)-th phase clock signal in the first DCA register group according to the 2ⁱ eye widths, so that each eye width is the same, in which m takes odd numbers in a range [1, 2ⁱ) in sequence; an n-th round of adjustment of the values of the first DCA register group includes: generating a new DQ data signal according to the optimal value of the first DCA register group obtained from the (n-1)-th round of adjustment, and obtaining 2ⁿ eye widths according to the new DQ data signal; and adjusting the value of the DCA register for a (k+1)-th phase clock signal in the first DCA register group according to the 2ⁿ eye widths, so that each adjacent eye width is the same, in which k takes odd numbers in a range [1, 2ⁿ) in sequence.

In the above implementation, through the n rounds of adjustments of the values of the first DCA register group, the duty cycle of the DQ data signal can be optimized. The method can be applied to the DQS clock signal and the DQ data signal generated by a 2ⁿ-phase system clock, which greatly expands the application scenarios of the present disclosure. Meanwhile, in the first n-1 rounds of adjustments, instead of obtaining the eye width of each phase in sequence and calculating a sum of the eye widths of the multiple phases, the sum of the eye widths of the multiple phases is directly obtained, which improves the efficiency.

In a possible implementation combined with the embodiment of the first aspect, the second system clock signal includes 2ⁿ-phase clock signals each having an independent DCA register, and n is an integer greater than or equal to 2; the adjusting the values of a second DCA register group includes: adjusting the values of DCA registers corresponding to first-type phase clock signals in the second DCA register group to obtain an optimal value of the DCA registers corresponding to the first-type phase clock signals, in which the first-type phase clock signals are those related to the clock jitter of the DQS clock signal; according to the optimal value of the DCA registers corresponding to the first-type phase clock signals obtained by adjustment, adjusting the values of DCA registers corresponding to second-type phase clock signals in the second DCA register group to obtain an optimal value of the DCA registers corresponding to the second-type phase clock signals, in which the second-type phase clock signals are those related to the duty cycle of the DQS clock signal.

In the above implementation, the values of the DCA registers corresponding to the first-type phase clock signals are adjusted to optimize the clock jitter of the DQS clock signal, and then the values of the DCA registers corresponding to the second-type phase clock signals are adjusted to optimize the duty cycle distortion of the DQS clock signal. This not only achieves the objective but also reduces the adjustment time, so that the training optimization time has a linear relationship with the number of phases of the system clock.

In a possible implementation combined with the embodiment of the first aspect, the adjusting the values of DCA registers corresponding to first-type phase clock signals in the second DCA register group includes: adjusting the values of DCA registers corresponding to first-type phase clock signals in the second DCA register group, and obtaining a first maximum-width data eye where correct sampled data is obtained by sampling the data transmitted by the DQ data signal using the DQS clock signal; and taking the value of the DCA register corresponding to the first maximum-width data eye as an optimal value of the DCA registers corresponding to the first-type phase clock signals in the second DCA register group.

In the above implementation, during the adjustment of the values of the DCA registers corresponding to the first-type phase clock signals, by continuously adjusting the values of the DCA registers, an eye width with correct data sampling can be obtained each time the value of a DCA register is adjusted. After multiple adjustments, a plurality of data eyes are obtained, and a maximum-width data eye is selected therefrom. The DCA register value corresponding to the maximum-width data eye is taken as an optimal value of the DCA register to obtain an optimal DCA setting, which ensures consistency between adjacent clock cycles, solves the problem of the cycle-to-cycle jitter of the DQS clock signal, and improves the read-write speed and reliability of the memory.

In a possible implementation combined with the embodiment of the first aspect, the adjusting the values of DCA registers corresponding to first-type phase clock signals in the second DCA register group, and obtaining a first maximum-width data eye where correct sampled data is obtained by sampling the data transmitted by the DQ data signal using the DQS clock signal includes: involving n-1 rounds of adjustments of the values of the DCA registers corresponding to the first-type phase clock signals in the second DCA register group; a first round of adjustment of the values of the DCA registers corresponding to the first-type phase clock signals in the second DCA register group includes: adjusting the value of the DCA register corresponding to a (2ⁿ⁻¹ + 1)-th phase clock signal multiple times, and obtaining a first maximum-width data eye where correct sampled data is obtained by sampling the data transmitted by the DQ data signal using the DQS clock signal; where i takes values from 2 to n-1 in sequence, an i-th round of adjustment of the values of the DCA registers corresponding to the first-type phase clock signals in the second DCA register group includes: adjusting the value of the DCA register for an (m*2ⁿ⁻ⁱ + 1)-th phase clock signal in the second DCA register group multiple times according to the optimal value of the second DCA register group obtained from the (i-1)-th round of adjustment, and obtaining a first maximum-width data eye where correct sampled data is obtained by sampling the data transmitted by the DQ data signal using the DQS clock signal, in which m takes odd numbers in a range [1, 2ⁱ) in sequence.

In the above implementation, through the n-1 rounds of adjustments of the values of the second DCA register group, the values of the DCA registers corresponding to the (2ⁿ⁻¹ + 1)-th phase clock signal and the (m*2ⁿ⁻ⁱ + 1)-th phase clock signal can be optimized, which solves the problem of the cycle-to-cycle jitter of the DQS clock signal, and the method can be applied to the DQS clock signal and the DQ data signal generated by a 2ⁿ-phase system clock, which greatly expands the application scenarios of the present disclosure.

In a possible implementation combined with the embodiment of the first aspect, the adjusting the values of DCA registers corresponding to second-type phase clock signals in the second DCA register group according to the optimal value of the DCA registers corresponding to the first-type phase clock signals obtained by adjustment includes: generating a new DQS clock signal according to the optimal value of the DCA registers corresponding to the first-type phase clock signals obtained by adjustment; adjusting the values of DCA registers corresponding to second-type phase clock signals, and obtaining a second maximum-width data eye where correct sampled data is obtained by sampling the data transmitted by the DQ data signal using the new DQS clock signal; taking the value of the DCA register corresponding to the second maximum-width data eye as an optimal value of the DCA registers corresponding to the second-type phase clock signals.

In the above implementation, during the adjustment of the values of the DCA registers corresponding to the second-type phase clock signals, by continuously adjusting the values of the DCA registers, an eye width with correct data sampling can be obtained each time a DCA register value is adjusted. After multiple adjustments, a plurality of data eyes are obtained, and a maximum-width data eye is selected therefrom. The DCA register value corresponding to the maximum-width data eye is taken as an optimal value of the DCA register to obtain an optimal duty cycle setting, so that the duty cycles of the odd and even cycles are optimized, thereby improving the read-write speed and reliability of the memory.

In a possible implementation combined with the embodiment of the first aspect, the adjusting the values of DCA registers corresponding to second-type phase clock signals, and obtaining a second maximum-width data eye where correct sampled data is obtained by sampling the data transmitted by the DQ data signal using the new DQS clock signal includes: adjusting the value of the DCA register for a (k+1)-th phase clock signal in the second DCA register group multiple times, and obtaining a second eye width where correct sampled data is obtained by sampling the data transmitted by the DQ data signal using the new DQS clock signal, in which k takes odd numbers in a range [1, 2ⁿ) in sequence.

In the above implementation, through the adjustment, the value of the DCA register corresponding to the (k + 1)-th phase clock signal can be optimized, thereby optimizing the duty cycle of the DQS clock signal. The method can be applied to the DQS clock signal and the DQ data signal generated by a 2ⁿ -phase system clock, which greatly expands the application scenarios of the present disclosure.

In a second aspect, an embodiment of the present disclosure further provides a memory controller, which is connected to a memory through a DQS clock line and a DQ data line, in which the DQS clock line is configured to transmit a DQS clock signal, the DQ data line is configured to transmit a DQ data signal, and the memory controller includes: a training engine configured to instruct the memory to adjust the values of the first DCA register group to obtain an optimal value of the first DCA register group, in which the values of the first DCA register group are related to the phase of a first system clock signal in the memory, and the first system clock signal is used to generate the DQ data signal; the training engine is further configured to instruct the memory to adjust the values of the second DCA register group according to the optimal value of the first DCA register group obtained by adjustment, so as to obtain an optimal value of the second DCA register group, in which the values of the second DCA register group are related to the phase of a second system clock signal in the memory, and the second system clock signal is used to generate the DQS clock signal.

In a possible implementation combined with the embodiment of the second aspect, the memory controller further includes: a measurement unit configured to obtain an eye width where correct sampled data is obtained by sampling the data transmitted by the DQ data signal using the DQS clock signal, and obtain a maximum eye width where correct sampled data is obtained by sampling the data transmitted by the DQ data signal using the DQS clock signal; and the training engine is further configured to instruct the memory to adjust the values of the first DCA register group according to the eye width, and instruct the memory to adjust the values of the second DCA register group according to the maximum eye width.

In a third aspect, an embodiment of the present disclosure further provides an electronic device, including a memory and the memory controller according to the embodiment of the second aspect, in which the memory controller is connected to the memory through a DQS clock line and a DQ data line, the DQS clock line is configured to transmit a DQS clock signal, and the DQ data line is configured to transmit a DQ data signal; the memory includes a first DCA register group, a second DCA register group, and a signal generation unit; the signal generation unit is configured to adjust the phase of a first system clock signal according to the values of the first DCA register group and generate the DQ data signal according to the first system clock signal, and adjust the phase of a second system clock signal according to the values of the second DCA register group and generate the DQS clock signal according to the second system clock signal.

The advantageous effects of the embodiments of the second aspect and the third aspect, may refer to those of the embodiment of the first aspect and possible implementations thereof.

Other features and advantages of the present disclosure have been elaborated in the subsequent description. The objectives and other advantages of the present disclosure can be realized and attained through the structures specifically specified in the written specification and the drawings.

### BRIEF DESCRIPTION OF THE DRAWINGS

In order to more clearly explain the technical solutions in the embodiments of the present disclosure or in the prior art, the drawings to be used in the description of the embodiments or the prior art will be briefly introduced as follows. Obviously, the drawings involved in the following description only illustrate some embodiments of the present disclosure, and persons of ordinary skill in the art can obtain other drawings from these drawings without paying any creative labor. The above and other objectives, features and advantages of the present disclosure will become more apparent from the drawings.
FIG. 1 illustrates a schematic diagram of a connection between a memory controller and a DDR memory in a DDR system.
FIG. 2 illustrates a schematic diagram of a principle of generating a transmission signal of a memory based on a 4-phase system clock according to an embodiment of the present disclosure.
FIG. 3 illustrates a flowchart of a method for optimizing a transmission signal of a memory according to an embodiment of the present disclosure.
FIG. 4 illustrates a schematic diagram of a data pattern for optimizing a duty cycle according to an embodiment of the present disclosure.
FIG. 5 illustrates a schematic diagram of a principle of adjusting a value of a DCA register for an IBCLK_DQ phase clock signal according to an embodiment of the present disclosure.
FIG. 6 illustrates a schematic diagram of a data pattern for optimizing a clock jitter and a duty cycle of a DQS clock signal according to an embodiment of the present disclosure.
FIG. 7 illustrates a schematic diagram of a structure of an electronic device according to an embodiment of the present disclosure.

### DETAILED DESCRIPTION OF THE PREFERRED EMBODIMENTS

The technical solutions in the embodiments of the present disclosure will be described below with reference to the drawings for the embodiments of the present disclosure. Obviously, those described are merely parts, rather than all, of the embodiments of the present disclosure. The following embodiments can serve as examples to more clearly explain the technical solutions of the present disclosure, but cannot be used to limit the protection scope of the present disclosure. It should be understood by persons skilled in the art that the following embodiments and features thereof can be combined with each other without conflict.

It should be noted that similar reference numerals and letters denote similar items in the following drawings. Therefore, once an item is defined in one drawing, it is not necessary to further define and explain the item in subsequent drawings. Meanwhile, in the description of the present disclosure, relational terms such as "first" and "second" are only used to distinguish one entity or operation from another entity or operation, and do not necessarily require or imply that there is any such actual relationship or sequence between these entities or operations. Furthermore, the terms "include" and "comprise" or any other variants thereof are intended to cover non-exclusive inclusions, so that a process, a method, an article or a device including a series of elements includes not only those elements, but also other elements not explicitly listed, or elements inherent in such process, method, article or device.

Moreover, the term "and/or" in the present disclosure is only an associative relationship describing associated objects, and indicates that there may be three relationships. For example, A and/or B may mean that A exists alone, A and B exist at the same time, and B exists alone.

In the description of the embodiments of the present disclosure, unless otherwise clearly specified and limited, the technical term "connection" may be a direct electrical connection or an indirect electrical connection through an intermediate medium.

In order to optimize the transmission signal of a memory (including a DQS clock signal and a DQ data signal), and improve the quality of the transmission signal, for example, by reducing a duty cycle distortion of the transmission signal of the memory, or a clock jitter (including a cycle-to-cycle jitter, i.e., different clock cycles have different durations) and a duty cycle distortion of a clock signal, the embodiments of the present disclosure provide a method for optimizing a transmission signal of a memory by adjusting the value of a Duty Cycle Adjuster (DCA) register.

The DDR5 (5^{th} generation DDR) specification provides a set of registers that can improve the phase relationship of system clocks (including 2ⁿ-phase clock signals), abbreviated as DCA registers. In which, each phase clock signal has an independent DCA register, and a value thereof is related to the phase of a system clock signal in a DDR memory. The system clock signal is used to generate a transmission signal of the DDR memory, i.e., to generate a DQS clock signal and a DQ data signal. A change in the value of the DCA register may change the phase of the system clock signal, thereby changing a high-level time and a low-level time of the DQS clock signal and the DQ data signal, so as to optimize the duty cycle distortion. In addition, a change in the value of the DCA register may also change a duration distribution between different clock cycles of the DQS clock signal and the DQ data signal, thereby optimizing the clock jitter. Therefore, by training the values of these registers, the duty cycle and the clock jitter of the transmission signal of the memory can be improved, thereby enhancing the read-write reliability of the memory. The method illustrated in the present disclosure can be applied to other memories which also generate a transmission signal of a memory based on a system clock signal and use DCA registers to change the phase of the system clock signal.

In which, the memory is connected to the memory controller through a DQS clock line and a DQ data line. The DQS clock line is used to transmit a DQS clock signal, and the DQ data line is used to transmit a DQ data signal. The DQ data signal is employed for data transmission, and the DQS clock signal is used to sample the DQ data signal to obtain the data transmitted by the DQ data signal.

In the DDR5 specification, the DQS clock signal and the DQ data signal of the DDR memory may be generated by 2-phase or 4-phase system clock signals. A 2-phase system clock includes two phase clock signals with different phases, and corresponding ideal phases are 0° and 180°, respectively. A 4-phase system clock includes 4 phase clock signals with different phases, and corresponding ideal phases are 0°, 90°, 180°, and 270°, respectively. By analogy, an 8-phase system clock includes 8 phase clock signals with different phases, and corresponding ideal phases are 0°, 45°, 90°, 135°, 180°, 225°, 270°, and 315° respectively.

FIG. 2 is a schematic diagram illustrating the generation of DQ data signals and DQS clock signals by a 4-phase system clock (including 4 phase clock signals, denoted as In-phase Clock (ICLK), Quadrature Clock (QCLK), Inverted and Buffered Clock (IBCLK), and Quadrature Inverted and Buffered Clock (QBCLK), for example), where "0", "1", "2", and "3" represent phase0, phase1, phase2, and phase3 of the DQ data signals and the DQS clock signals, respectively. A phase relationship between the ICLK phase clock signal and the QCLK phase clock signal determines an eye width of phase0; a phase relationship between the QCLK phase clock signal and the IBCLK phase clock signal determines an eye width of phase 1 ; a phase relationship between the IBCLK phase clock signal and the QBCLK phase clock signal determines an eye width of phase2; and a phase relationship between the QBCLK phase clock signal and the ICLK phase clock signal determines an eye width of phase3. The 4 different phase clock signals may cause mismatches among phase0, phase1, phase2, and phase3 of the DQS clock signal or the DQ data signal, which not only worsens the problem of an intra-cycle duty cycle distortion of the DDR interface, but also worsens the clock jitter and leads to inconsistent amplitudes of the duty cycle distortions of adjacent cycles.

In which, ICLK, QCLK, IBCLK, and QBCLK illustrated in FIG. 2 may also be represented by other numerals or letters, which are merely used to distinguish different phase clock signals. In which, the clock jitter may cause inconsistent durations between adjacent cycles, e.g., the duration of an odd cycle is inconsistent with the duration of an even cycle. As an example, regarding the DQS clock signal in FIG. 2, an interval from a first r0 to r1 represents one cycle (referred to as an even cycle), and an interval from r1 to the next r0 represents a next cycle (referred to as an odd cycle). Due to the clock jitter, these two cycles may have different durations. For instance, a first cycle has a duration of 9 ns, and a second cycle has a duration of 11 ns. The purpose of the optimization is to make the two durations consistent, such as both being10 ns.

In some implementations, the DQ data signal and the DQS clock signal may be generated based on the same system clock signal. In other possible implementations, the DQ data signal and the DQS clock signal may be generated based on different system clock signals. As illustrated in FIG. 2, the DQ data signal is generated based on a first system clock signal (ICLK_DQ, QCLK_DQ, IBCLK_DQ, QBCLK_DQ), and the DQS clock signal is generated based on a second system clock signal (ICLK_DQS, QCLK_DQS, IBCLK_DQS, QBCLK_DQS).

Since the DQ data signal and the DQS clock signal can be generated based on different system clock signals, the duty cycles and the cycle-to-cycle jitter amplitudes thereof are not entirely consistent. To reduce influence of the duty cycle distortions and the cycle-to-cycle jitters of the DQS clock signal and the DQ data signal on training results, the present disclosure adopts a novel approach: by training and adjusting the values of a first DCA register group, the eye width of each phase of the DQ data signal is made the same (herein, "the same" means within a certain error range, i.e., the difference therebetween is within the error range), the training method ensures the training results of the DQ data signal are not affected by the initial duty cycle and the cycle-to-cycle jitter of the DQS clock signal. On the basis of the optimized DQ data signal, the duty cycle and the cycle-to-cycle jitter of the DQS clock signal are further optimized. The entire process does not require multiple iterations of mutual optimization between the DQS clock signal and the DQ data signal. By adjusting the values of the DCA registers, the duty cycles of the DQS clock signal and the DQ data signal generated by the memory itself are optimized in memory, instead of adjusting the duty cycles of the DQS clock signal and DQ data signal at the side of the memory controller by an additional hardware circuit after the DQS clock signal and DQ data signal are generated, so it is unnecessary to add additional hardware circuits and reduce the hardware overhead.

During optimization, the method for optimizing the transmission signal of the memory according to the present disclosure may firstly train and optimize the DQ data signal in the memory, and then train and optimize the DQS data signal in the memory based on the optimized DQ data signal. When the DQ data signal or the DQS data signal in the memory is trained and optimized, the clock jitter of the DQ data signal or the DQS data signal may be trained and optimized firstly, followed by the training and the optimization of the duty cycle distortion of the DQ data signal or the DQS data signal. The total training and optimization time has a linear correlation with the number of phases of the system clock and does not increase exponentially as the number of phases rises. Assuming that the training and optimization time required to adjust the values of the DCA registers in each round is T, and the number of phases of the system clock used to generate the DQS clock signal or the DQ data signal is N, then the total training and optimization time for adjusting the values of the first DCA register group or the second DCA register group is T*logN. For example:

In a case of using a 2-phase clock to generate the DQS clock signal (or the DQ data signal), the total training and optimization time is 1*T. In a case of using a 4-phase clock to generate the DQS clock signal (or the DQ data signal), the total training and optimization time is 2*T. In a case of using an 8-phase clock to generate the DQS clock signal (or the DQ data signal), the total training and optimization time is 3*T.

In which, the DQS clock signal or the DQ data signal generated by the 2-phase clock may only have a duty cycle distortion without a clock jitter. The DQS clock signal or the DQ data signal generated by the 4-phase clock or a clock with more phases may have both the duty cycle distortion and the clock jitter.

The method for optimizing the transmission signal of the memory illustrated in the present disclosure can reduce the duty cycle distortion and the clock jitter in the transmission signal of the memory. Moreover, it can effectively mitigate situations where the duty cycles and the cycle-to-cycle jitter amplitudes of the DQS clock signal and the DQ data signal are inconsistent. This method can not only improve the DQS clock signal and the DQ data signal generated by the 4-phase system clock but also be applied to improve those generated by the 2-phase system clock or a system clock with more phases. The method for optimizing the transmission signal of the memory according to the embodiment of the present disclosure is described below with reference to FIG. 3, and it can be applied to the memory controller.

S1 : adjusting the values of a first DCA register group and generating a DQ data signal based on an optimal value of the first DCA register group obtained by adjustment.

In which, the values of the first DCA register group are related to the phase of the first system clock signal in the memory, and the first system clock signal is used to generate the DQ data signal. By adjusting the values of the first DCA register group, the duty cycle distortion of the DQ data signal in the memory can be optimized, or both the clock jitter and the duty cycle distortion of the DQ data signal can be optimized. In which, the first system clock signal includes 2ⁿ-phase clock signals each having an independent DCA register, where n is an integer greater than or equal to 1.

In an implementation, the values of the first DCA register group may be adjusted according to values obtained from experiments or simulations. By adjusting the values of the first DCA register group, the phase of the first system clock signal can reach (or approach) an ideal phase. For example, in the case of the 4-phase system clock, by adjusting the values of the first DCA register group, the phases of the 4 phase clock signals can reach (or approach) 0°, 90°, 180°, and 270° respectively, thereby optimizing both the clock jitter and the duty cycle distortion of the DQ data signal.

When n is an integer greater than or equal to 2, the process of adjusting the values of the first DCA register group may be as follows: adjusting the values of DCA registers corresponding to first-type phase clock signals in the first DCA register group (which includes 2ⁿ DCA registers) to obtain an optimal value of the DCA registers corresponding to the first-type phase clock signals, so as to optimize the clock jitter of the DQ data signal; based on the optimal value of the DCA registers corresponding to the first-type phase clock signals obtained by adjustment, adjusting the values of DCA registers corresponding to second-type phase clock signals in the first DCA register group to obtain an optimal value of the DCA registers corresponding to the second-type phase clock signals, so as to optimize the duty cycle distortion of the DQ data signal. By first training and optimizing the clock jitter of the transmission signal of the memory, and then training and optimizing the duty cycle distortion of the transmission signal of the memory, the objective can be achieved while reducing the adjustment time, thereby ensuring that the training and optimization time has a linear relationship with the number of phases of the system clock.

In an implementation, it is also possible to directly adjust the values of the DCA registers corresponding to the second-type phase clock signals without adjusting the values of the DCA registers corresponding to the first-type phase clock signals. Compared with the way that firstly adjusts the values of the DCA registers corresponding to the first-type phase clock signals and then adjusts the values of the DCA registers corresponding to the second-type phase clock signals, this way requires more time for adjustment.

When n = 1, the process of adjusting the values of the first DCA register group may be directly adjusting the values of the DCA registers corresponding to the second-type phase clock signals in the first DCA register group to optimize the duty cycle distortion of the DQ data signal.

In which, the first-type phase clock signals are phase clock signals related to the clock jitter of the DQ data in the transmission signal of the memory, and the second-type phase clock signals are phase clock signals related to the duty cycle of the DQ data signal of the memory.

In an implementation, the process of adjusting the values of the first DCA register group may be as follows: adjusting the values of the first DCA register group to obtain 2ⁿ eye widths, within each of which correct sampled data is obtained by sampling the DQ data signal using the DQS clock signal (i.e., correct data can be sampled throughout the eye width), and each of the eye widths representing a phase difference between a corresponding phase clock signal and a subsequent phase clock signal; adjusting the values of the first DCA register group based on the 2ⁿ eye widths, so that the 2ⁿ eye widths where correct sampled data is obtained by sampling a new DQ data signal using the DQS clock signal are the same, wherein the new DQ data signal is generated based on the adjusted values of the first DCA register group.

For example, taking a 4-phase system clock as an example, there are 4 eye widths, which are assumed to be phase0 eye width (abbreviated as phase0), phase1 eye width (abbreviated as phase1), phase2 eye width (abbreviated as phase2), and phase3 eye width (abbreviated as phase3). As can be seen from FIG. 2, the phase0 eye width represents a phase difference between a corresponding phase clock signal (ICLK) and a subsequent phase clock signal (QCLK); the phase1 eye width represents a phase difference between a corresponding phase clock signal (QCLK) and a subsequent phase clock signal (IBCLK); the phase2 eye width represents a phase difference between a corresponding phase clock signal (IBCLK) and a subsequent phase clock signal (QBCLK); and the phase3 eye width represents the phase difference between a corresponding phase clock signal (QBCLK) and a subsequent phase clock signal (ICLK). Similarly, taking an 8-phase system clock as an example, there are 8 eye widths, which are assumed to be phase0 eye width, phase1 eye width, phase2 eye width, phase3 eye width, phase4 eye width, phase5 eye width, phase6 eye width, and phase7 eye width.

The eye widths may be obtained as follows. When the data transmitted by the DQ data signal is sampled using the DQS clock signal, a first delay of the DQS clock signal at a transition point where first incorrect sampled data transitions to correct data may be recorded, and then the DQS clock signal is continuously delayed. When correct data is sampled consistently, the DQS clock signal is kept delayed until incorrect data is sampled. A second delay of the DQS clock signal at a transition point where the correct sampled data transitions to incorrect data, and the eye width may be a delay difference between the first delay and the second delay.

In which, when obtaining 2ⁿ eye widths where correct sampled data is obtained by sampling the DQ data signal (or new DQ data signal) using the DQS clock signal, it can be done by sampling 2ⁿ types of data transmitted by the DQ data signal (or new DQ data signal) respectively using the DQS clock signal to obtain 2ⁿ eye widths with correct sampled data, with each type of data corresponding to one eye width.

For example, taking n=2 as an example, 4 data patterns are involved, which may be 1000 (or 0111), 0100 (or 1011), 0010 (or 1101), 0001 (or 1110). The data transmitted by the DQ data signal is set to 1000, the DQ data signal is sampled using the DQS clock signal, and the DQS clock signal is gradually delayed, so that an interval where a rising edge r0 of the DQS clock signal returns data "1" can be obtained, and this interval is the phase0 eye width. Similarly, the data transmitted by the DQ data signal is set to 0100, the DQ data signal is sampled using the DQS clock signal, and the DQS clock signal is gradually delayed, so that an interval where a falling edge f0 of the DQS clock signal returns data "1" can be obtained, and this interval is the phase1 eye width. Similarly, the data transmitted by the DQ data signal is set to 0010, the DQ data signal is sampled using the DQS clock signal, and the DQS clock signal is gradually delayed, so that the interval where a rising edge r1 of the DQS clock signal returns data "1" can be obtained, and this interval is the phase2 eye width. Similarly, the data transmitted by the DQ data signal is set to 0001, the DQ data signal is sampled using the DQS clock signal, and the DQS clock signal is gradually delayed, so that the interval where a falling edge f1 of the DQS clock signal returns data "1" can be obtained, and this interval is the phase3 eye width. The data transmitted by the DQ data signal may be set to 0111, the DQ data signal is sampled using the DQS clock signal, and the DQS clock signal is gradually delayed, so that an interval where the rising edge r0 of the DQS clock signal returns data "0" can be obtained, and this interval is the phase0 eye width. Examples of other phases are omitted. In which, the rising edge r0, the falling edge f0, the rising edge r1, and the falling edge f1 are sampling clock edges for sampling phase0, phase1, phase2, and phase3 respectively.

For example, taking n=3 as an example, 8 data patterns are involved, which may be 10000000 (or 01111111), 01000000 (or 10111111), 00100000 (or 11011111), 00010000 (or 11101111), 00001000 (or 11110111), 00000100 (or 11111011), 00000010 (or 11111101), 00000001 (or 11111110). For example, the data transmitted by the DQ data signal is set to 01111111, the DQ data signal is sampled using the DQS clock signal, and the DQS clock signal is gradually delayed, so that an interval where a rising edge r0 of the DQS clock signal returns data "0" can be obtained, and this interval is the phase0 eye width. Similarly, the data transmitted by the DQ data signal is set to 10111111, the DQ data signal is sampled using the DQS clock signal, and the DQS clock signal is gradually delayed, so that an interval where a falling edge f0 of the DQS clock signal returns data "0" can be obtained, and this interval is the phase1 eye width. By analogy, the data transmitted by the DQ data signal is set to 11111101, the DQ data signal is sampled using the DQS clock signal, and the DQS clock signal is gradually delayed, so that an interval where a rising edge r3 of the DQS clock signal returns data "0" can be obtained, and this interval is the phase6 eye width. Similarly, the data transmitted by the DQ data signal is set to 11111110, the DQ data signal is sampled using the DQS clock signal, and the DQS clock signal is gradually delayed, so that an interval where a falling edge f3 of the DQS clock signal returns data "0" can be obtained, and this interval is the phase7 eye width.

When the values of the first DCA register group are adjusted, multiple adjustments of the values of the DCA registers are involved. Each time the values of the DCA registers are adjusted, it is necessary to generate a new DQ data signal based on the adjusted values of the DCA registers. Next, the new DQ data signal is sampled using the DQS clock signal to obtain 2ⁿ eye widths with correct sampled data (referred to as the new 2ⁿ eye widths). It is checked whether the new 2ⁿ eye widths are the same, and if so, the adjustment of the values of the DCA registers is stopped; otherwise, the above adjustment process is repeated. After multiple adjustments, the 2ⁿ eye widths can be made the same as much as possible. In this implementation, the optimal value of the first DCA register group is a value of the first DCA register group when the 2ⁿ eye widths where correct sampled data is obtained by sampling the DQ data signal using the DQS clock signal are the same.

It should be understood that the first DCA register group includes 2ⁿ DCA registers. Each time the values of the first DCA register group are adjusted, it is can be applied to adjust only the values of some DCA registers in the first DCA register group, rather than necessarily adjusting the values of all DCA registers in the first DCA register group.

In an implementation, the process of adjusting the values of the first DCA register group based on the 2ⁿ eye widths may involve n rounds of adjustments of the values of the first DCA register group. For example, when n=2, two rounds of adjustments of the values of the first DCA register group are involved; and when n=3, three rounds of adjustments of the values of the first DCA register group are involved.

In which, a first round of adjustment of the values of the first DCA register group includes: based on a sum of the first 2ⁿ⁻¹eye widths and a sum of the last 2ⁿ⁻¹ eye widths, adjusting the value of the DCA register for a (2ⁿ⁻¹ + 1)-th phase clock signal in the first DCA register group, so that a sum of the first 2ⁿ⁻¹ eye widths is equal to a sum of the last 2ⁿ⁻¹ eye widths; when n=2, adjusting the value of the DCA register for a 3rd phase clock signal (corresponding to IBCLK_DQ in FIG. 2) in the first DCA register group; and when n=3, adjusting the value of the DCA register for a 5th phase clock signal in the first DCA register group.

Where i takes values from 2 to n-1 in sequence, an i-th round of adjustment of the values of the first DCA register group includes: generating a new DQ data signal based on an optimal value of the first DCA register group obtained from the (i-1)-th round of adjustment, and obtaining 2ⁿ new eye widths based on the new DQ data signal; adjusting the value of the DCA register for an (m*2ⁿ⁻ⁱ + 1)-th phase clock signal in the first DCA register group based on the 2ⁿ new eye widths, so that each sum of eye widths is the same. Each sum of eye widths is a sum of 2ⁿ⁻ⁱ adjacent eye widths, involving a total of 2ⁱ eye width sums.

In which, m takes odd numbers in a range [1, 2ⁱ) in sequence. The value of m changes as i increases. For example, when i=2, m takes values 1 and 3 in sequence; when i=3, m takes values 1, 3, 5, and 7 in sequence; when i=4, m takes values 1, 3, 5, 7, 9, 11, 13, and 15 in sequence. Assuming n=3 (8 phases are used in total), when i=2, 4 eye width sums are involved in total, and each sum of eye widths is a sum of 2 adjacent eye widths, such as a sum of eye widths of phase0 and phase 1 , a sum of eye widths of phase2 and phase3, a sum of eye widths of phase4 and phase5 eye widths, and a sum of the eye widths of phase6 and phase7 eye widths. Assuming n=4 (16 phases are used in total), when i=2, four (i.e., 2²) eye width sums are involved, and each sum of eye widths is a sum of 4 adjacent eye widths, such as a sum of the eye widths of phase0 and phase1 and phase2 and phase3, a sum of the eye widths of phase4 and phase5 and phase6 and phase7 eye widths, a sum of the eye widths of phase8 and phase9 and phase 10 and phase11, and a sum of the eye widths of phase 12 and phase 13 and phase14 and phase 15. Assuming n=4 (16 phases are used in total), when i=3, eight (i.e., 2³) eye width sums are involved, and each sum of eye widths is a sum of 2 adjacent eye widths, such as a sum of the eye widths of phase0 and phase1, a sum of the eye widths of phase2 and phase3 , a sum of the eye widths of phase4 and phase5 , a sum of the eye widths of phase6 and phase7 eye widths, a sum of the eye widths of phase8 and phase9, a sum of the eye widths of phase10 and phase 11, a sum of the eye widths of phase12 and phase13, and a sum of the eye widths of phase 14 and phase 15.

An n-th round of adjustment the values of the first DCA register group includes: generating a new DQ data signal based on the optimal value of the first DCA register group obtained from the (n-1)-th round of adjustment, and obtaining 2ⁿ new eye widths based on the new DQ data signal; adjusting the value of the DCA register for a (k + 1)-th phase clock signal in the first DCA register group based on the 2ⁿ new eye widths, so that the eye widths are the same, where k takes odd numbers in a range [1, 2ⁿ) in sequence, and the value of k changes as i increases. For example, when n=2, k takes values 1 and 3 in sequence; when n=3, k takes values 1, 3, 5, and 7 in sequence; and when i=4, k takes values 1, 3, 5, 7, 9, 11, 13, and 15 in sequence.

In each round of adjustment of the values of the first DCA register group, multiple adjustments of the values of the DCA registers may be involved. Each time the values of the DCA registers are adjusted, a new DQ data signal may be generated based on the adjusted values of the DCA registers, and then 2ⁿ new eye widths may be generated based on the new DQ data signal. Further, the values of the DCA registers are adjusted based on the 2ⁿ new eye widths, and then the above process is repeated until the optimal DCA value is obtained. The process of obtaining the 2ⁿ new eye widths is to sample the new DQ data signal using the DQS clock signal to obtain 2ⁿ eye widths with correct sampled data.

Among the phase clock signals mentioned above, the phase clock signals corresponding to the DCA trained and optimized in the last round (the n-th round) are the second-type phase clock signals, and other phase clock signals are first-type phase clock signals. For example, in a case of a 4-phase system clock, the first-type phase clock signal is the 3^{rd} phase clock signal, and the second-type phase clock signals include the 2^{nd} phase clock signal and the 4^{th} phase clock signal. For another example: in a case of an 8-phase system clock, the first-type phase clock signals include the 5^{th}, the 3^{rd}, and the 7^{th} phase clock signals; and the second-type phase clock signals include the 2^{nd}, the 4^{th}, the 6^{th}, and the 8^{th} phase clock signals.

To better understand the adjustment process described above, examples are given below for illustration.

### Embodiment 1

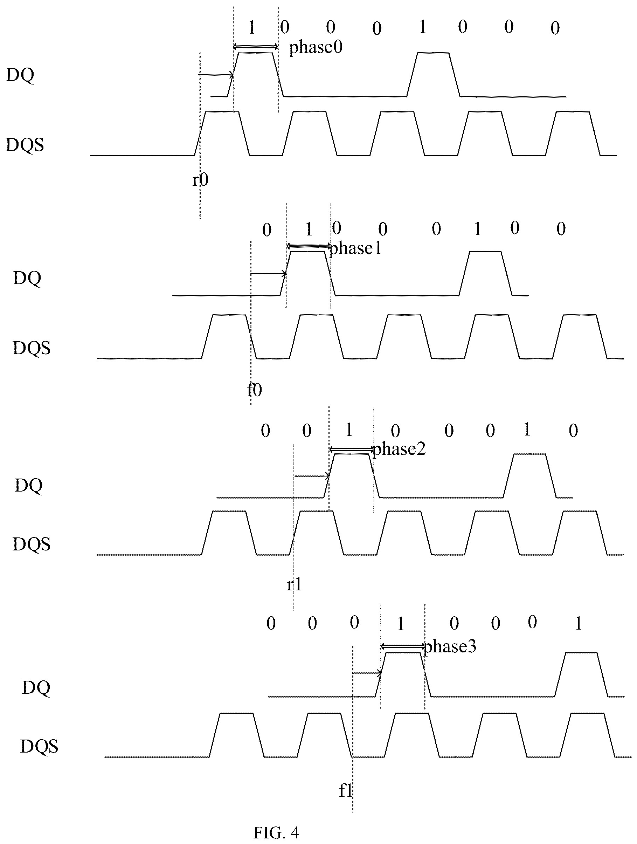

Taking n=2 as an example, four different data patterns, i.e., 1000, 0100, 0010, and 0001, are used to train and optimize the duty cycle of the DQ data signal, and r0, f0, r1, and f1 of the DQS clock signal are the sampling clock edges for sampling the four phase data of the DQ data signal, respectively, as schematically illustrated in FIG. 4.

Step 1: setting the data transmitted by the DQ data signal to 1000, sampling the DQ data using the DQS clock signal, checking whether the data returned by the rising edge r0 of the DQS clock signal is 1, and gradually delaying the DQS clock signal, so that an interval where the rising edge r0 returns data "1" can be obtained, and this interval is an eye width of phase0.

Step 2: setting the data transmitted by the DQ data signal to 0100, sampling the DQ data using the DQS clock signal, checking whether the data returned by the falling edge f0 of the DQS clock signal is 1, and gradually delaying the DQS clock signal, so that an interval where the falling edge f0 returns data "1" can be obtained, and this interval is an eye width of phase1.

Step 3: setting the data transmitted by the DQ data signal to 0010, sampling the DQ data using the DQS clock signal, checking whether the data returned by the rising edge r1 of the DQS clock signal is 1, and gradually delaying the DQS clock signal, so that an interval where the rising edge r1 returns data "1" can be obtained, and this interval is an eye width of phase2.

Step 4: setting the data transmitted by the DQ data signal to 0001, sampling the DQ data using the DQS clock signal, checking whether the data returned by the falling edge f1 of the DQS clock signal is 1, and gradually delaying the DQS clock signal, so that an interval where the falling edge f1 returns data "1" can be obtained, and this interval is an eye width of phase3.

At this point, the eye widths of phase0, phase1, phase2 and phase3 are obtained.

Step 5: comparing the summed eye widths of (phase0 + phase1) and the summed eye widths of (phase2 + phase3):
1. After the eye widths of phase0, phase1, phase2, and phase3 are obtained, a sum of the eye widths of phase0 and phase1, and a sum of the eye widths of phase2 and phase3 may be compared, and when the sum of the eye widths of phase0 and phase1 is greater than that of phase2 and phase3, the value of the DCA register for IBCLK_DQ (the 3^{rd} phase clock signal) is decreased. Afterwards, new eye widths of phase0, phase1, phase2, and phase3 are obtained based on the new DQ data signal, until the sum of the eye widths of phase0 and phase1 less than or equal to the sum of the eye widths of phase2 and phase3. The value of the DCA register when the absolute value of [(phase0 + phase1) - (phase2 + phase3)] is minimized is the optimal value of the DCA register for IBCLK_DQ.
2. When the sum of the eye widths of phase0 and phase 1 is less than the sum of the eye widths of phase2 and phase3, the value of the DCA register for IBCLK_DQ is increased until the sum of the eye widths of phase0 and phase1 is great than or is equal to the sum of the eye widths of phase2 and phase3. When the absolute value of the sum of the eye widths of phase0 and phase1 minus the sum of the eye widths of phase2 and phase3 is minimized, the value of the DCA register is the optimal value of the DCA register for IBCLK_DQ.
3. When the sum of the eye widths of phase0 and phase is equal to the sum of the eye widths of phase2 and phase3, there is no need to adjust the value of the DCA register for IBCLK_DQ. The "is equal to" here refers to equality within a certain precision range. At this point, the phase of IBCLK_DQ is optimal.

Step 6: comparing the eye widths of phase0 and phase1:
1. When phase0 is greater than phase1, the value of the DCA register for QCLK_DQ (the 2^{nd} phase clock signal) is decreased. Afterwards, new eye widths of phase0 and phase1 are obtained based on the new DQ data signal until phase0 is less than or is equal to phase1. When the absolute value of the eye width of phase0 minus the eye width of phase1 is minimized, the value of the DCA register is the optimal value of the DCA register for QCLK_DQ.
2. When phase0 is less than phase 1, the value of the DCA register for QCLK_DQ is increased. Afterwards, new eye widths of phase0 and phase1 are obtained based on the new DQ data signal until the eye width of phase0 is great than or is equal to the eye width of phase1. When the absolute value of the eye width of phase0 minus the eye width of phase1 is minimized, the value of the DCA register is the optimal value of the DCA register for QCLK_DQ.
3. When phase0 = phase1, there is no need to adjust the value of the DCA register for QCLK_DQ. The "equality" here refers to equality within a certain precision range. At this point, the phase of QCLK_DQ is optimal.

Step 7: comparing the eye widths of phase2 and phase3:
1. When the eye width of phase2 is greater than the eye width of phase3, the value of the DCA register for QBCLK_DQ (the 4^{th} phase clock signal) is decreased. Afterwards, new eye widths of phase2 and phase3 are obtained based on the new DQ data signal until the eye width of phase2 is less than or is equal to the eye width of phase3. When the absolute value of the eye width of phase2 minus the eye width of phase3 is minimized, the value of the DCA register is the optimal value of the DCA register for QBCLK_DQ.
2. When the eye width of phase2 is less than the eye width of phase3, the value of the DCA register for QBCLK_DQ is increased. Afterwards, new eye widths of phase2 and phase3 are obtained based on the new DQ data signal until the eye width of phase2 is great than or is equal to the eye width of phase3. When the absolute value of the eye width of phase2 minus the eye width of phase3, the value of the DCA register is minimized is the optimal value of the DCA register for QBCLK_DQ.
3. When the eye width of phase2 is equal to the eye width of phase3, there is no need to adjust the value of the DCA register for QBCLK_DQ. The "is equal to" here refers to equality within a certain precision range. At this point, the adjustments of optimal values of the DCA registers for QCLK_DQ, IBCLK_DQ, and QBCLK_DQ are completed, and the duty cycle of the DQ data signal is optimal.

Steps 6 and 7 described above can be performed simultaneously.

### Embodiment 2

Taking n=3 as an example, eight different data patterns, i.e., 10000000, 01000000, 00100000, 00010000, 00001000, 00000100, 00000010, and 00000001, are used to train and optimize the duty cycle of the DQ data signal, and r0, f0, r1, f1, r2, f2, r3, and f3 of the DQS clock signal are the sampling clock edges for sampling the eight phase data of the DQ data signal, respectively.

Step 1: setting the data transmitted by the DQ data signal to 10000000, sampling the DQ data using the DQS clock signal, checking whether the data returned by the rising edge r0 of the DQS clock signal is 1, and gradually delaying the DQS clock signal, so that an interval where the rising edge r0 returns data "1" can be obtained, and this interval is the eye width of phase0.

Step 2: setting the data transmitted by the DQ data signal to 01000000, sampling the DQ data using the DQS clock signal, checking whether the data returned by the falling edge f0 of the DQS clock signal is 1, and gradually delaying the DQS clock signal, so that an interval where the falling edge f0 returns data "1" can be obtained, and this interval is the eye width of phase1.

Step 3: setting the data transmitted by the DQ data signal to 00100000, sampling the DQ data using the DQS clock signal, checking whether the data returned by the rising edge r1 of the DQS clock signal is 1, and gradually delaying the DQS clock signal, so that an interval where the rising edge r1 returns data "1" can be obtained, and this interval is the eye width of phase2.

Step 4: setting the data transmitted by the DQ data signal to 00010000, sampling the DQ data using the DQS clock signal, checking whether the data returned by the falling edge f1 of the DQS clock signal is 1, and gradually delaying the DQS clock signal, so that an interval where the falling edge f1 returns data "1" can be obtained, and this interval is the eye width of phase3.

Step 5: setting the data transmitted by the DQ data signal to 00001000, sampling the DQ data using the DQS clock signal, checking whether the data returned by the rising edge r2 of the DQS clock signal is 1, and gradually delaying the DQS clock signal, so that an interval where the rising edge r2 returns data "1" can be obtained, and this interval is the eye width of phase4.

Step 6: setting the data transmitted by the DQ data signal to 00000100, sampling the DQ data using the DQS clock signal, checking whether the data returned by the falling edge f2 of the DQS clock signal is 1, and gradually delaying the DQS clock signal, so that an interval where the falling edge f2 returns data "1" can be obtained, and this interval is the eye width of phase5.

Step 7: setting the data transmitted by the DQ data signal to 00000010, sampling the DQ data using the DQS clock signal, checking whether the data returned by the rising edge r3 of the DQS clock signal is 1, and gradually delaying the DQS clock signal, so that an interval where the rising edge r3 returns data "1" can be obtained, and this interval is the eye width of phase6.

Step 8: setting the data transmitted by the DQ data signal to 00000001, sampling the DQ data using the DQS clock signal, checking whether the data returned by the falling edge f3 of the DQS clock signal is 1, and gradually delaying the DQS clock signal, so that an interval where the falling edge f3 returns data "1" can be obtained, and this interval is the eye width of phase7.

At this point, the eye widths of phase0, phase1, phase2, phase3, phase4, phase5, phase6, and phase7 are obtained.

Step 9: comparing a sum of the eye widths of phase0 and phase1 and phase2 and phase3, and a sum of the eye widths of phase4 and phase5 and phase6 and phase7:
1. When the sum of the eye widths of phase0 and phase1 and phase2 and phase3 is greater than the sum of the eye widths of phase4 and phase5 and phase6 and phase7, the value of the DCA register for the 5^{th} phase clock signal is decreased. Afterwards, new eye widths of phase0, phase1, phase2, phase3, phase4, phase5, phase6, and phase7 are obtained based on the new DQ data signal, until the sum of the eye widths of phase0 and phase1 and phase2 and phase3 is less than or is equal to the sum of the eye widths of phase4 and phase5 and phase6 and phase7.
   When the absolute value of the sum of the eye widths of phase0 and phase1 and phase2 and phase3 minus the sum of the eye widths of phase4 and phase5 and phase6 and phase7 is minimized, the value of the DCA register is the optimal value of the DCA register for the 5^{th} phase clock signal.
2. When the sum of the eye widths of phase0 and phase1 and phase2 and phase3 is less than the sum of the eye widths of phase4 and phase5 and phase6 and phase7, the value of the DCA register for the 5^{th} phase clock signal is increased, until the sum of the eye widths of phase0 and phase1 and phase2 is great than or is equal to the sum of the eye widths of phase4 and phase5 and phase6 and phase7. When the sum of the eye widths of phase0 and phase1 and phase2 and phase3 minus the sum of the eye widths of phase4 and phase5 and phase6 and phase7| is minimized, the value of the DCA register is the optimal value of the DCA register for the 5^{th} phase clock signal.
3. When the sum of the eye widths of phase0 and phase1 and phase2 and phase3 is equal to the sum of the eye widths of phase4 and phase5 and phase6 and phase7, there is no need to adjust the value of the DCA register for the 5^{th} phase clock signal. The "is equal to" here refers to equality within a certain precision range. At this point, the phase of the 5^{th} phase clock signal is optimal.

Step 10: comparing the eye widths of the sum of the eye widths of phase0 and phase1 and the sum of the eye widths of phase2 and phase3.
1. When the sum of the eye widths of phase0 and phase1 is greater than the sum of the eye widths of phase2 and phase3, the value of the DCA register for the 3^{rd} phase clock signal is decreased. Afterwards, new eye widths of phase0, phase1, phase2, and phase3 are obtained based on the new DQ data signal, until the sum of the eye widths of phase0 and phase1 is less than or is equal to the sum of the eye widths of phase2 and phase3. When the absolute value of the sum of the eye widths of phase0 and phase1 minus the sum of the eye widths of phase2 and phase3 is minimized, the value of the DCA register is the optimal value of the DCA register for the 3^{rd} phase clock signal.
2. When the sum of the eye widths of phase0 and phase1 is less than the sum of the eye widths of phase2 and phase3, the value of the DCA register for the 3^{rd} phase clock signal is increased, until the sum of the eye widths of phase0 and phase1 is great than or is equal to the sum of the eye widths of phase2 and phase3. When the sum of the eye widths of phase0 and phase1 minus the sum of the eye widths of phase2 and phase3 is minimized, the value of the DCA register is the optimal value of the DCA register for the 3^{rd} phase clock signal.
3. When the sum of the eye widths of phase0 and phase1 is equal to the sum of the eye widths of phase2 and phase3, there is no need to adjust the value of the DCA register for the 3^{rd} phase clock signal. The " is equal to " here refers to equality within a certain precision range. At this point, the phase of the 3^{rd} phase clock signal is optimal.

Step 11: comparing the eye widths of a sum of the eye widths of phase4 and phase5, and a sum of the eye widths of phase6 and phase7:
1. When the sum of the eye widths of phase4 and phase5 is greater than the sum of the eye widths of phase6 and phase7, the value of the DCA register for the 7^{th} phase clock signal is decreased. Afterwards, new eye widths of phase4, phase5, phase6, and phase7 are obtained based on the new DQ data signal, until the sum of the eye widths of phase4 and phase5 is less than or is equal to the sum of the eye widths of phase6 and phase7. When the absolute value of the sum of the eye widths of phase4 and phase5 minus the sum of the eye widths of phase6 and phase7 is minimized, the value of the DCA register is the optimal value of the DCA register for the 7^{th} phase clock signal.
2. When the sum of the eye widths of phase4 and phase5 is less than the sum of the eye widths of phase6 and phase7, the value of the DCA register for the 7^{th} phase clock signal is increased until the sum of the eye widths of phase4 and phase5 is great than or is equal to the sum of the eye widths of phase6 and phase7. When the sum of the eye widths of phase4 and phase5 minus the sum of the eye widths of phase6 and phase7 is minimized, the value of the DCA register is the optimal value of the DCA register for the 7^{th} phase clock signal.
3. When the sum of the eye widths of phase4 and phase5 is equal to the sum of the eye widths of phase6 and phase7, there is no need to adjust the value of the DCA register for the 3^{rd}phase clock signal. The " is equal to " here refers to equality within a certain precision range. At this point, the phase of the 3^{rd}phase clock signal is optimal.

Steps 10 and 11 described above can be performed simultaneously.

Step 12: comparing the eye widths of phase0 and phase1, comparing the eye widths of phase2 and phase3, comparing the eye widths of phase4 and phase5, and comparing the eye widths of phase6 and phase7, respectively:
1. The value of the DCA register for the 2^{nd} phase clock signal is adjusted by comparing the eye widths of phase0 and phase1. When phase0 is greater than phase1, the value of the DCA register for the 2^{nd} phase clock signal is decreased. Afterwards, new eye widths of phase0 and phase1 are obtained based on the new DQ data signal, until phase0 is less than or is equal to phase1. The value of the DCA register when the absolute value of the eye width of phase0 minus the eye width of phase1 is minimized is the optimal value of the DCA register for the 2^{nd} phase clock signal. When phase0 is less than phase1, the value of the DCA register for the 2^{nd} phase clock signal is increased. Afterwards, new eye widths of phase0 and phase1 are obtained based on the new DQ data signal, until phase0 is great than or is equal to phase1. The value of the DCA register when the absolute value of the eye width of phase0 minus the eye width of phase 1 is minimized is the optimal value of the DCA register for the 2^{nd} phase clock signal. When the eye width of phase0 is equal to the eye width of phase1, there is no need to adjust the DCA register for the 2^{nd} phase clock signal.
2. The value of the DCA register for the 4^{th} phase clock signal is adjusted by comparing the eye widths of phase2 and phase3. When phase2 is greater than phase3, the value of the DCA register for the 4^{th} phase clock signal is decreased. Afterwards, new eye widths of phase2 and phase3 are obtained based on the new DQ data signal, until phase2 is less than or is equal to phase3. The value of the DCA register when the absolute value of the eye width of phase2 minus the eye width of phase3 is minimized is the optimal value of the DCA register for the 4^{th} phase clock signal. When phase2 is less than phase3, the value of the DCA register for the 4^{th} phase clock signal is increased. Afterwards, new eye widths of phase2 and phase3 are obtained based on the new DQ data signal, until phase2 is great than or is equal to phase3. The value of the DCA register when the absolute value of the eye width of phase2 minus the eye width of phase3 is minimized is the optimal value of the DCA register for the 4^{th} phase clock signal. When the eye width of phase2 is equal to the eye width of phase3, there is no need to adjust the DCA register for the 4^{th} phase clock signal.
3. The value of the DCA register for the 6^{th} phase clock signal is adjusted by comparing the eye widths of phase4 and phase5. When phase4 is greater than phase5, the value of the DCA register for the 6^{th} phase clock signal is decreased. Afterwards, new eye widths of phase4 and phase5 are obtained based on the new DQ data signal, until phase4 is less than or is equal to phase5. The value of the DCA register when the absolute value of the eye width of phase4 minus the eye width of phase5 is minimized is the optimal value of the DCA register for the 6^{th} phase clock signal. When the eye width of phase4 is less than the eye width of phase5, the value of the DCA register for the 6^{th} phase clock signal is increased. Afterwards, new eye widths of phase4 and phase5 are obtained based on the new DQ data signal, until phase4 is great than or is equal to phase5. The value of the DCA register when the absolute value of the eye width of phase4 minus the eye width of phase5 is minimized is the optimal value of the DCA register for the 6^{th} phase clock signal. When phase4 is equal to phase5, there is no need to adjust the DCA register for the 6th phase clock signal.
4. The value of the DCA register for the 8^{th} phase clock signal is adjusted by comparing the eye widths of phase6 and phase7. When phase6 is greater than phase7, the value of the DCA register for the 8^{th} phase clock signal is decreased. Afterwards, new eye widths of phase6 and phase7 are obtained based on the new DQ data signal, until phase6 is less than or is equal to phase7. The value of the DCA register when the absolute value of the eye width of phase6 minus the eye width of phase7 is minimized is the optimal value of the DCA register for the 8^{th} phase clock signal. When the eye width of phase6 is less than the eye width of phase7, the value of the DCA register for the 8^{th} phase clock signal is increased. Afterwards, new eye widths of phase6 and phase7 are obtained based on the new DQ data signal, until the eye width of phase6 is great than or is equal to the eye width of phase7. The value of the DCA register when the absolute value of the eye width of phase6 minus the eye width of phase7 is minimized is the optimal value of the DCA register for the 8^{th} phase clock signal. When phase6 = phase7, there is no need to adjust the DCA register for the 8th phase clock signal.

At this point, the adjustments of the optimal values of the DCA registers for the 5^{th} the 3^{rd}, the 7^{th}, the 2^{nd}, the 4^{th}, the 6^{th}, and the 8^{th} phase clock signals are completed, and the duty cycle of the DQ data signal is optimal.

In an implementation, during the adjustment of the values of the first DCA register group, instead of sequentially obtaining the eye width of each phase and then calculating the sum of the eye widths of a plurality of phases, the sum of the eye widths of a plurality of phases can be obtained directly, so that the efficiency can be improved. In this implementation, adjusting the values of the first DCA register group also involves n rounds of adjustments of the values of the first DCA register group.

In which, the first round of adjustment of the values of the first DCA register group includes: adjusting the value of the DCA register for a (2ⁿ⁻¹ + 1)-th phase clock signal in the first DCA register group based on a first eye width and a second eye width, so that the eye width corresponding to the first 2ⁿ⁻¹ phase clock signals is equal to the eye width corresponding to the last 2ⁿ⁻¹ phase clock signals. In which, the first eye width is an eye width corresponding to the first 2ⁿ⁻¹ phase clock signals, and the second eye width is an eye width corresponding to the last 2ⁿ⁻¹ phase clock signals. Each eye width represents a phase difference between a corresponding phase clock signal and a subsequent phase clock signal.

Where i takes values from 2 to n-1 in sequence, the i-th round of adjustment of the values of the first DCA register group includes: generating a new DQ data signal based on the optimal value of the first DCA register group obtained from the (i-1)-th round of adjustment; obtaining 2ⁱ eye widths based on the new DQ data signal, in which each eye width is a sum of the eye widths corresponding to adjacent 2ⁿ⁻ⁱ phase clock signals; adjusting the value of the DCA register for the (m*2ⁿ⁻ⁱ + 1)-th phase clock signal in the first DCA register group based on the 2ⁱ eye widths, so that each eye width is the same, where m takes odd numbers in a range [1, 2ⁱ) in sequence.

The n-th round of adjustment of the values of the first DCA register group includes: generating a new DQ data signal based on the optimal value of the first DCA register group obtained from the (n-1)-th round of adjustment; obtaining 2ⁿ eye widths based on the new DQ data signal; adjusting the value of the DCA register for a (k + 1)-th phase clock signal in the first DCA register group based on the 2ⁿ eye widths, so that each adjacent eye width is the same, where k takes odd numbers in a range [1, 2ⁿ) in sequence.

The principle of adjusting the values of the first DCA register group in this embodiment is similar to the aforementioned principle of adjusting the values of the first DCA register group based on the 2ⁿ eye widths. The difference lies in that this embodiment can directly obtain the sum of the eye widths of a plurality of phases.

For better understanding, examples are given below for illustration.

### Embodiment 3

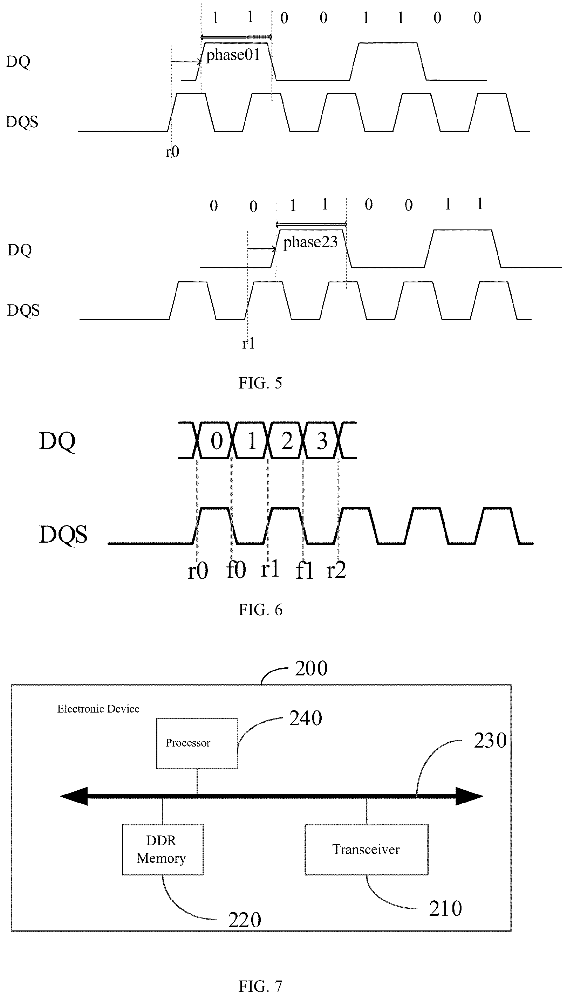

Taking n=2 as an example, during the adjustment of the value of the DCA register for IBCLK_DQ, the data transmitted by the DQ data signal may be set to 1100 (or 0011) and 0011 (or 1100) and sampled using the DQS clock signal to obtain an eye width of phase01 (a sum of the eye widths of phase0 and phase1) and an eye width of phase23 (a sum of the eye widths of phase2 and phase3). Afterwards, the value of the DCA register for IBCLK_DQ is adjusted according to the eye widths of phase01 and phase23. The schematic diagram of this principle is illustrated in FIG. 5, and the specific process is as follows.

Step 1: setting the data transmitted by the DQ data signal to 1100 (or 0011), sampling the DQ data using the DQS clock signal, checking whether the data returned by the rising edge r0 (odd cycle) of the DQS clock signal is 1 (or 0), and gradually delaying the DQS clock signal, so that an interval where the rising edge r0 returns data "1" (or "0") can be obtained, and this interval is the eye width of phase01 .

Step 2: setting the data transmitted by the DQ data signal to 0011 (or 1100), sampling the DQ data using the DQS clock signal, checking whether the data returned by the rising edge r1 (even cycle) of the DQS clock signal is 1 (or 0), and gradually delaying the DQS clock signal, so that an interval where the rising edge r1 returns data "1" (or "0") can be obtained, and this interval is the eye width of phase23.

### Step 3: comparing the eye widths of phase01 and phase23:

1. When phase01 is greater than phase23, the value of the DCA register for IBCLK_DQ is decreased. Afterwards, new eye widths of phase01 and phase23 are obtained based on the new DQ data signal until phase01 is less than or is equal to phase23. The value of the DCA register when the absolute value of the eye width of phase01minus the eye width of phase23 is minimized is the optimal value of the DCA register for IBCLK_DQ.
2. When phase01 is less than phase23, the value of the DCA register for IBCLK_DQ is increased. Afterwards, new eye widths of phase01 and phase23 are obtained based on the new DQ data signal until phase01 is great than or is equal to phase23. The value of the DCA register when the absolute value of the eye width of phase01 minus phase23 is minimized is the optimal value of the DCA register for IBCLK_DQ.
3. When the eye width of phase01 is equal to the eye width of phase23, there is no need to adjust the value of the DCA register for IBCLK_DQ (the second method) .

Here, " is equal to " refers to equality within a certain precision range. At this point, the phase of IBCLK_DQ is optimal.

After the value of the DCA register for IBCLK_DQ is adjusted to be optimal, it is also necessary to adjust the values of the DCA registers for QCLK_DQ and QBCLK_DQ. During the adjustment of the value of the DCA register for QCLK_DQ, it is necessary to compare the eye widths of phase0 and phase1, and this process is the same as Step 6 in Embodiment 1. During the adjustment of the value of the DCA register for QBCLK_DQ, it is necessary to compare the eye widths of phase2 and phase3, and this process is the same as Step 7 in Embodiment 1.

### Embodiment 4

Taking n=3 as an example, during the adjustments of the values of the DCA registers for the 5^{th}, the 3^{rd}, and the 7^{th} phase clock signals, the data transmitted by the DQ data signal may be set to specific values, and sampled using the DQS clock signal, so as to obtain an eye width of phase0123 (a sum of the eye widths of phase0, phase1, phase2, and phase3), an eye width of phase4567 (a sum of the eye widths of phase4, phase5, phase6, and phase7), as well as eye widths of phase01, phase23, phase45 (a sum of the eye widths of phase4 and phase5), and an eye width of phase67 (a sum of the eye widths of phase6 and phase7). Afterwards, the value of the DCA register for the 5^{th} phase clock signal is adjusted based on the eye widths of phase0123 and phase4567; the value of the DCA register for the 3^{rd} phase clock signal is adjusted based on the eye widths of phase01 and phase23; and the value of the DCA register for the 7^{th} phase clock signal is adjusted based on the eye widths of phase45 and phase67. In this process, instead of obtaining the eye width of each phase and then calculating the eye width sum based thereon, the eye widths of phase0123, phase4567, phase01, phase23, phase45, and phase67 can be obtained directly through sampling. The specific process is as follows.

Step 1: setting the data transmitted by the DQ data signal to 11110000 (or 00001111), sampling the DQ data using the DQS clock signal, checking whether the data returned by the rising edge r0 of the DQS clock signal is 1 (or 0), and gradually delaying the DQS clock signal, so that an interval where the rising edge r0 returns data "1" (or "0") can be obtained, and this interval is the eye width of phase0123 (i.e., a first eye width).

Step 2: setting the DQ data signal to 00001111 (or 11110000), sampling the DQ data using the DQS clock signal, checking whether the data returned by the rising edge r2 of the DQS clock signal is 1 (or 0), and gradually delaying the DQS clock signal, so that an interval where the rising edge r2 returns data "1" (or "0") can be obtained, and this interval is the eye width of phase4567 (i.e., a second eye width).

Step 3: comparing the eye widths of phase0123 and phase4567 to obtain an optimal value of the DCA register for the 5^{th} phase clock signal.

Step 4: setting the data transmitted by the DQ data signal to 11001100 (or 00110011), sampling the DQ data using the DQS clock signal, checking whether the data returned by the rising edge r0 of the DQS clock signal is 1 (or 0), and gradually delaying the DQS clock signal, so that an interval where the rising edge r0 returns data "1" (or "0") can be obtained, and this interval is the eye width of phase01. Afterwards, it checks whether the data returned by the rising edge r2 of the DQS clock signal is 1 (or 0), and gradually delays the DQS clock signal, so that an interval where the rising edge r2 returns data "1" (or "0") can be obtained, and this interval is the eye width of phase45. In Step 4, the data transmitted by the DQ data signal may also be set to 11000000 (or 00111111) and 00001100 (or 11110011) to obtain the eye widths of phase01 and phase45, respectively.

Step 5: setting the data transmitted by the DQ data signal to 00110011 (or 11001100), sampling the DQ data using the DQS clock signal, checking whether the data returned by the rising edge r1 of the DQS clock signal is 1 (or 0), and gradually delaying the DQS clock signal, so that an interval where the rising edge r1 returns data "1" (or "0") can be obtained, and this interval is the eye width of phase23. Afterwards, it checks whether the data returned by the rising edge r3 of the DQS clock signal is 1 (or 0), and gradually delays the DQS clock signal, so that an interval where the rising edge r3 returns data "1" (or "0") can be obtained, and this interval is the eye width of phase67. In Step 5, the data transmitted by the DQ data signal may also be set to 00110000 (or 11001111) and 00000011 (or 11111100) to obtain the eye widths of phase23 and phase67, respectively.

Step 6: comparing the eye widths of phase01 and phase23 to obtain an optimal value of the DCA register for the 3^{rd} phase clock signal; and comparing the eye widths of phase45 and phase67 to obtain an optimal value of the DCA register for the 7^{th} phase clock signal.

Step 7: setting the data transmitted by the DQ data signal to 10101010 (or 01010101), sampling the DQ data using the DQS clock signal, checking whether the data returned by the rising edge r0 of the DQS clock signal is 1 (or 0), and gradually delaying the DQS clock signal, so that an interval where the rising edge r0 returns data "1" (or "0") can be obtained, and this interval is the eye width of phase0. Next, an interval where the rising edge r1 returns data "1" (or "0") is obtained, which is the eye width of phase2. Next, an interval where the rising edge r2 returns data "1" (or "0") is obtained, which is the eye width of phase4. Next, an interval where the rising edge r3 returns data "1" (or "0") is obtained, which is the eye width of phase6. In this step, the DQ data may also be set to 10000000, 00100000, 00001000, and 00000010 to obtain the eye widths of phase0, phase2, phase4, and phase6, respectively.

Step 8: setting the data transmitted by the DQ data signal to 01010101, sampling the DQ data using the DQS clock signal, checking whether the data returned by the f0 of the DQS clock signal is 1, and gradually delaying the DQS clock signal, so that an interval where f0 returns data "1" can be obtained, and this interval is the eye width of phase1. Next, an interval where f1 returns data "1" is obtained, which is the eye width of phase3. Next, an interval where f2 returns data "1" is obtained, which is the eye width of phase5. Next, an interval where f3 returns data "1" is obtained, which is the eye width of phase7. In this step, the DQ data may also be set to 01000000, 00010000, 00000100, and 00000001 to obtain the eye widths of phase1, phase3, phase5, and phase7 respectively.

Step 9: comparing the eye widths of phase0 and phase1 to obtain an optimal DCA value for the 2^{nd} phase clock signal; comparing the eye widths of phase2 and phase3 to obtain an optimal DCA value for the 4^{th} phase clock signal; comparing the eye widths of phase4 and phase5 to obtain an optimal DCA value for the 6^{th} phase clock signal; and comparing the eye widths of phase6 and phase7 to obtain an optimal DCA value for the 8^{th} phase clock signal.

S2: adjusting the values of a second DCA register group based on the optimal value of the first DCA register group obtained by adjustment, and generating a DQS clock signal based on the optimal value of the second DCA register group obtained by adjustment.

In which, by adjusting the values of the second DCA register group, the duty cycle distortion of the DQ data signal in the memory can be optimized, or both the clock jitter and the duty cycle distortion of the DQ data signal can be optimized. The values of the second DCA register group are related to the phase of the second system clock signal in the memory, and the second system clock signal is used to generate the DQS clock signal. The second system clock signal includes 2ⁿ-phase clock signals each having an independent DCA register, where n is an integer greater than or equal to 1.

In an implementation, the values of the second DCA register group may be adjusted according to values obtained from experiments or simulations. By adjusting the values of the second DCA register group, the phase of the second system clock signal can reach (or approach) an ideal phase. For example, in the case of the 4-phase system clock, by adjusting the values of the second DCA register group, the phases of the 4 phase clock signals can reach (or approach) 0°, 90°, 180°, and 270° respectively, thereby optimizing both the clock jitter and the duty cycle distortion of the DQ data signal in the memory.

In an implementation, during the adjustment of the values of the second DCA register group (including 2ⁿ DCA registers), the values of the DCA registers may be adjusted by, for example, obtaining a maximum-width data eye where correct sampled data is obtained by sampling the data transmitted by the DQ data signal using the DQS clock signal, and taking the value of the DCA register corresponding to the maximum-width data eye as an optimal value of the DCA register. This process involves multiple adjustments of the value of the DCA register. An data eye can be obtained each time the value of the DCA register is adjusted, and a plurality of data eyes are obtained after multiple adjustments, so that a maximum-width data eye can be selected therefrom. The value of the DCA register corresponding to the maximum-width data eye is taken as the optimal value of the DCA register, thereby completing the adjustment of the value of the DCA register. The optimal value of the second DCA register group is the value of the DCA register corresponding to the maximum-width data eye where correct sampled data is obtained by sampling the data transmitted by the DQ data signal using the DQS clock signal.

For example, assuming the initial value of a certain DCA register is 0, based on which the DQS clock signal can be generated, and the data transmitted by the DQ data signal is sampled using this DQS clock signal. By continuously delaying the DQS clock signal, an eye width within which correct data is sampled (i.e., correct data can be sampled throughout the eye width) can be obtained. Next, the initial value of the DCA register is assumed to be adjusted to 1, based on which a new DQS clock signal can be generated, and the data transmitted by the DQ data signal is sampled using the new DQS clock signal. By continuously delaying the new DQS clock signal, a new eye width within which correct data is sampled can be obtained. This process is repeated continuously to obtain a plurality of data eyes, and then a maximum-width data eye is selected, where the maximum-width data eye may be the one with a largest eye width.

For example, taking the adjustment of the value of the DCA register corresponding to the phase clock signal IBCLK_DQS described above as an example: during the adjustment of the value of the DCA register, the value of the DCA register corresponding to the phase clock signal IBCLK_DQS may be increased, and when the eye width becomes larger, the value of the DCA register corresponding to the phase clock signal IBCLK_DQS is continuously increased until the eye width starts to decrease. Alternatively, the value of the DCA register corresponding to the phase clock signal may be decreased, and when the eye width becomes larger, the value of the DCA register corresponding to the phase clock signal IBCLK_DQS is continuously decreased until the eye width starts to decrease. When the eye width to become smaller as the value of the DCA register corresponding to the phase clock signal IBCLK_DQS is increased, the process returns to the value of the previous DCA register to decrease the value of the DCA register corresponding to the phase clock signal IBCLK_DQS. At this time, if the data eye also becomes smaller, the value of the previous DCA register is the optimal value of the DCA register.

In an implementation, when n is an integer greater than or equal to 2, the process of adjusting the value of the second DCA register group may be as follows: adjusting the values of the DCA registers corresponding to the first-type phase clock signals in the second DCA register group to obtain an optimal value of the DCA registers corresponding to the first-type phase clock signals, so as to optimize the clock jitter of the DQS clock signal; based on the optimal value of the DCA registers corresponding to the first-type phase clock signals obtained after adjustment, adjusting the values of the DCA registers corresponding to the second-type phase clock signals in the second DCA register group to obtain an optimal value of the DCA registers corresponding to the second-type phase clock signals, so as to optimize the duty cycle distortion of the DQS signal, wherein the first-type phase clock signals are those related to the clock jitter of the DQS clock signal. When n = 1, the process of adjusting the values of the second DCA register group may be as follows: adjusting the values of the DCA registers corresponding to the second-type phase clock signals in the second DCA register group to optimize the duty cycle distortion of the DQS clock signal, wherein the second-type phase clock signals are those related to the duty cycle of the DQS clock signal.

In an implementation, it is also possible to directly adjust the values of the DCA registers corresponding to the second-type phase clock signals without adjusting the values of the DCA registers corresponding to the first-type phase clock signals. Compared with the way that firstly adjusts the values of the DCA registers corresponding to the first-type phase clock signals and then adjusts the values of the DCA registers corresponding to the second-type phase clock signals, this way requires more time for adjustment.

In a possible implementation, the process of adjusting the values of the DCA registers corresponding to the first-type phase clock signals and the second-type phase clock signals in the second DCA register group may be as follows: adjusting the values of the DCA registers corresponding to the first-type phase clock signals and the second-type phase clock signals according to the values obtained from experiments or simulations.

In a possible implementation, the process of adjusting the values of the DCA register corresponding to the first-type phase clock signals in the second DCA register group is as follows: adjusting the values of the DCA registers corresponding to the first-type phase clock signals in the second DCA register group, and obtaining a first maximum-width data eye where correct sampled data is obtained by sampling the data transmitted by the DQ data signal using the DQS clock signal, and taking the value of the DCA register corresponding to the first maximum-width data eye as an optimal value of the DCA registers corresponding to the first-type phase clock signals in the second DCA register group. In this implementation, multiple adjustments of the values of the DCA registers corresponding to the first-type phase clock signals are involved. A data eye can be obtained each time the value of the DCA register is adjusted, and a plurality of data eyes are obtained after multiple adjustments, so that a maximum-width data eye can be selected therefrom. The value of the DCA register corresponding to the maximum-width data eye is taken as the optimal value of the DCA registers corresponding to the first-type phase clock signals, thus completing the adjustment of the values of the DCA registers corresponding to the first-type phase clock signals.

For example, during the adjustment of the values of the DCA registers corresponding to the first-type phase clock signals in the second DCA register group, the process of obtaining the first maximum-width data eye where correct sampled data is obtained by sampling the data transmitted by the DQ data signal using the DQS clock signal involves n-1 rounds of adjustments of the values of the DCA registers corresponding to the first-type phase clock signals in the second DCA register group.

The 1^{st} round of adjustment of the values of the DCA registers corresponding to the first-type phase clock signals in the second DCA register group includes: adjusting the value of the DCA register corresponding to the (2ⁿ⁻¹ + 1)-th phase clock signal multiple times, and obtaining a first maximum-width data eye where correct sampled data is obtained by sampling the data transmitted by the DQ data signal using the DQS clock signal. The value of the DCA register corresponding to the first maximum-width data eye obtained is an optimal value of the DCA register for the (2ⁿ⁻¹ + 1)-th phase clock signal.

Where i takes values from 2 to n-1 in sequence, the i-th round of adjustment of the values of the DCA registers corresponding to the first-type phase clock signals in the second DCA register group includes: adjusting the value of the DCA register corresponding to the (m*2ⁿ⁻ⁱ+ 1)-th phase clock signal in the second DCA register group multiple times, based on the optimal value of the second DCA register group obtained from the (i-1)-th round of adjustment, and obtaining a first maximum-width data eye where correct sampled data is obtained by sampling the data transmitted by the DQ data signal using the DQS clock signal, wherein m takes odd numbers in a range [1, 2ⁱ) in sequence. When the value of the DCA register corresponding to the (m*2ⁿ⁻ⁱ + 1)-th phase clock signal in the second DCA register group is adjusted multiple times based on the optimal value of the second DCA register group obtained from the (i-1)-th round, a new DQS clock signal is generated based on the optimal value of the second DCA register group obtained from the (i-1)-th round, a first maximum-width data eye where correct sampled data is obtained by sampling the data transmitted by the DQ data signal using the new DQS clock signal, and the value of the DCA register corresponding to the first maximum-width data eye is taken as the optimal value.

In an implementation, the process of adjusting the values of the DCA registers corresponding to the second-type phase clock signals in the second DCA register group based on the optimal value of the DCA registers corresponding to the first-type phase clock signals obtained by adjustment may be as follows: generating a new DQS clock signal based on the optimal value of the DCA registers corresponding to the first-type phase clock signals obtained by adjustment; adjusting the values of the DCA registers corresponding to the second-type phase clock signals, obtaining a second maximum-width data eye where correct sampled data is obtained by sampling the data transmitted by the DQ data signal using the new DQS clock signal, and taking the value of the DCA register corresponding to the second maximum-width data eye as an optimal values of the DCA registers corresponding to the second-type phase clock signals.

In an implementation, the process of adjusting the values of the DCA registers corresponding to the second-type phase clock signals, and obtaining a second maximum-width data eye where correct sampled data is obtained by sampling the data transmitted by the DQ data signal using the new DQS clock signal includes: adjusting the value of the DCA register corresponding to the (k + 1)-th phase clock signal in the second DCA register group multiple times, and obtaining a second eye width where correct sampled data is obtained by sampling the data transmitted by the DQ data signal using the new DQS clock signal, wherein k takes odd numbers in a range [1, 2ⁿ) in sequence.

Taking n=2 as an example, the process of adjusting the values of the DCA registers corresponding to the first-type phase clock signals, and obtaining a first maximum-width data eye where correct sampled data is obtained by sampling the data transmitted by the DQ data signal using the DQS clock signal may be as follows: adjusting the value of the DCA register corresponding to the 3^{rd} phase clock signal (IBCLK_DQS) multiple times, and obtaining a first data eye where correct sampled data is obtained by sampling the data transmitted by the DQ data signal using two adjacent rising edges of the DQS clock signal, under each value of the DCA register, and selecting a first maximum-width data eye from the obtained multiple first data eyes.

Taking n=2 as an example, the process of adjusting the values of the DCA registers corresponding to the second-type phase clock signals, and obtaining a second maximum-width data eye where correct sampled data is obtained by sampling the data transmitted by the new DQ data signal using the new DQS clock signal may be as follows: adjusting the value of the DCA register corresponding to the 2^{nd} phase clock signal, and obtaining a second maximum-width data eye where correct sampled data is obtained by sampling the data transmitted by the new DQ data signal using rising edges and falling edges of even cycles in the new DQS clock signal; adjusting the value of the DCA register corresponding to the 4^{th} phase clock signal, and obtaining a second maximum-width data eye where correct sampled data is obtained by sampling the data transmitted by the new DQ data signal using rising edges and falling edges of odd cycles in the new DQS clock signal.

For a better understanding of the above processes, specific examples are given below for illustration.

### Embodiment 5

Taking the above phase clock signals ICLK_DQS, QCLK_DQS, IBCLK_DQS, and QBCLK_DQS as examples, FIG. 6 illustrates a schematic diagram of a data pattern for optimizing a clock jitter. DQ data is to 1100 (which may also be any other value such as 0011, 1010, or 0101), and r0 and r1 are two rising edges of adjacent cycles of a DQS clock signal. The DQ data is sampled using the two rising edges r0 and r1 of the DQS clock signal, and the data sampled by the rising edge r0 and the rising edge r1 is compared. When the rising edge r0 samples data "1" and the rising edge r1 samples data "0" (when the DQ data is of any other value, the data sampled by the rising edge r0 and the rising edge r1 also changes; for example, if the DQ data is 1010, the rising edge r0 samples data "1" and the rising edge r1 samples data "1"), the data is considered correct. The DQS clock signal is gradually delayed, a transition point where incorrect data transitions to correct data is recorded as a first delay, and a transition point where correct data transitions to incorrect data is recorded as a second delay. An eye width may be obtained based on the first delay and the second delay, and the eye width is determined by the widths of the DQ data "1" and "0" and the clock period of r0 and r1 in the DQS clock signal. By gradually changing the value of the DCA register corresponding to the phase clock signal IBCLK_DQS, a plurality of eye widths can be obtained, and the value of the DCA register when the eye width is the maximum is an optimal value of the DCA register. The process of adjusting the value of the DCA register corresponding to the phase clock signal IBCLK_DQS is as follows.

When the value of the DCA register for IBCLK_DQS is to be increased, it is continuously increased as the eye width becomes larger, until the eye width starts to decrease. When the value of the DCA register for IBCLK_DQS is to be decreased, it is continuously decreased as the eye width becomes larger, until the eye width starts to decrease. When the eye width becomes smaller as the value of the DCA register for IBCLK_DQS is increased, the process returns to the value of the previous DCA register to decrease the value of the DCA register corresponding to the phase clock signal IBCLK_DQS. At this time, if the eye width also decreases, the value of the previous DCA register is the optimal value of the DCA register.

After the optimal value of the DCA register corresponding to the phase clock signal IBCLK_DQS is written into the DCA register, the DQ data is set to 1010 (which may also be any other value such as 0101), r0 and f0 are the rising edge and the falling edge of the even cycles of the DQS clock signal, and r1 and f1 are the rising edge and the falling edge of the odd cycles of the DQS clock signal. The duty cycle of the even cycle can be adjusted by adjusting the phase (the value of the DCA register) of the QCLK_DQS phase clock signal, and the duty cycle of the odd cycle can be adjusted by adjusting the phase (the value of the DCA register) of the phase clock signal QBCLK_DQS. The DQ data is sampled using the DQS clock signal, and the data sampled by the rising edge r0 and the falling edge f0 is compared. When the rising edge r0 samples data "1" and the falling edge f0 samples data "0" (when the DQ data is of any other value, the data sampled by the rising edge r0 and the falling edge f0 also changes), the data is considered correct. The DQS clock signal is gradually delayed to obtain the eye width of the even cycle. The eye width depends on the duty cycle of the DQ data signal (or the DQS clock signal) of the even cycle. By gradually changing the value of the DCA register corresponding to the phase clock signal QCLK_DQS, the value of the DCA register corresponding to the phase clock signal QCLK_DQS when the eye width is the maximum is the optimal value of the DCA register.

Similarly, for the DQS clock signal and the DQ data of the odd cycle, the data sampled by the rising edge r1 and the falling edge f1 is compared. When the rising edge r1 samples data "1" and the falling edge f1 samples data "0", the data is considered correct. The DQS clock signal is gradually delayed to obtain the eye width of the odd cycle, and the eye width depends on the duty cycle of the DQ data signal (or the DQS clock signal) of the odd cycle. By gradually changing the value of the DCA register corresponding to the phase clock signal QBCLK_DQS, the value of the DCA register when the eye width is the maximum is the optimal value of the DCA register. The solution of adjusting the values of the DCA registers corresponding to the phase clock signals QCLK_DQS and QBCLK_DQS is the same as that of adjusting the value of the DCA register corresponding to the phase clock signal IBCLK_DQS.

The above adjustment process may be briefly summarized as follows.
[101] The initial value of the DCA register is set to 0. QCLK_DQS, IBCLK_DQS, and QBCLK_DQS each have an independent DCA register.
[102] The DQ data is set to 1100, and the DQ data sampled by the rising edges r0 and r1 is checked. When the value returned by the rising edge is "10", the sampled data is considered correct. The DQS clock signal is gradually delayed, and the eye width may be obtained according to the delay where correct data is sampled.
[103] The value of the DCA register for IBCLK_DQS is gradually changed (i.e., the phase of IBCLK_DQS is adjusted) until the data eye width is the maximum. The value of the DCA register for IBCLK_DQS corresponding to the maximum-width data eye is written into the DCA register as the optimal value. At this point, the flow of improving the clock jitter is completed.
[104] The DQ data is set to 1010, and the data sampled by the rising edge r0 and the falling edge f0 of the even cycle of the DQS clock signal is checked. When the values returned by the rising edge and the falling edge are "10", the sampled data is considered correct. The DQS clock signal is gradually delayed, and the eye width may be obtained according to the delay where correct data is sampled.
[105] The value of the DCA register for QCLK_DQS is gradually changed (i.e., the phase of QCLK is adjusted) until the eye width is maximized. The value of the DCA register for QCLK_DQS corresponding to the maximum-width data eye is written into the DCA register as the optimal value. At this point, the duty cycle of the even cycle is adjusted to be optimal.
[106] The DQ data is set to 1010, and the data sampled by the rising edge r1 and the falling edge f1 of the odd cycle of the DQS clock signal is checked. When the values returned by the rising edge and the falling edge are "10", the sampled data is considered correct. The DQS clock signal is gradually delayed, and the eye width can be obtained according to the delay where correct data is sampled.
[107] The value of the DCA register for QBCLK_DQS is changed (i.e., the phase of QBCLK is adjusted) until the data eye is the maximum. The value of the DCA register for QBCLK_DQS corresponding to the maximum-width data eye is written into the DCA register as the optimal value. At this point, the duty cycle of the odd cycle is adjusted to be optimal. The above steps [104], [105], [106], and [107] can be performed simultaneously, i.e., the adjustments of the duty cycles of the even cycle and the odd cycle can be carried out simultaneously.

### Embodiment 6

Taking the generation of the transmission signal of the memory using an 8-phase system clock as an example, each phase clock signal has its own DCA register. The adjustment process is as follows:
[201] The initial value of the DCA register is set to 0, and the 2^{nd} to the 8^{th} phase clock signals each have an independent DCA register.
[202] The DQ data is set to 11110000 (which may also be 00001111, 10001000, or 01110111), and the DQ data sampled by the rising edge 0 and the rising edge 4 of the DQS clock signal is checked. When the returned value is "10", the sampled data is considered correct. The DQS clock signal is gradually delayed, and the eye width can be obtained according to the delay where correct data is sampled.
[203] The value of the DCA register corresponding to the 5^{th} phase clock signal is gradually changed until the eye width is maximized. The value of the DCA register when the eye width is maximized is written into the DCA register as the optimal value.
[204] The DQ data is set to 11001100 (which may also be any other value such as 00110011), and the data sampled by the rising edge 0 and the rising edge 2 of the DQS clock signal is checked. When the returned value are "10", the sampled data is considered correct. The DQS clock signal is gradually delayed, and the eye width can be obtained according to the delay where correct data is sampled.
[205] The value of the DCA register corresponding to the 3^{rd} phase clock signal is gradually changed until the eye width is maximized. The value of the DCA register when the eye width is maximized is written into the DCA register as the optimal value.
[206] The DQ data is set to 11001100 (which may also be any other value such as 00110011), and the data sampled by the rising edge 4 and the rising edge 6 of the DQS clock signal is checked. When the returned value is "10", the sampled data is considered correct. The DQS clock signal is gradually delayed, and the eye width can be obtained according to the delay where correct data is sampled.
[207] The value of the DCA register corresponding to the 7^{th} phase clock signal is gradually changed until the eye width is maximized. The value of the DCA register when the data eye is the maximum is written into the DCA register as the optimal value. Steps [204] to [207] can be performed simultaneously.
[208] The DQ data is set to 10101010 (which may also be any other value such as 01010101), and the data sampled by the rising edge 0 and the falling edge 1 of the DQS clock signal is checked. When the returned value is "10", the sampled data is considered correct. The DQS clock signal is gradually delayed, and the eye width can be obtained according to the delay where correct data is sampled.
[209] The value of the DCA register corresponding to the 2^{nd} phase clock signal is gradually changed until the eye width is maximized. The value of the DCA register when the eye width is maximized is written into the DCA register as the optimal value.
[210] The DQ data is set to 10101010 (which may also be any other value such as 01010101), and the data sampled by the rising edge 2 and the falling edge 3 of the DQS clock signal is checked. When the returned value is "10", the sampled data is considered correct. The DQS clock signal is gradually delayed, and the eye width can be obtained according to the delay where correct data is sampled.
[211] The value of the DCA register corresponding to the 4^{th} phase clock signal is gradually changed until the eye width is maximized. The value of the DCA register when the eye width is maximized is written into the DCA register as the optimal value.
[212] The DQ data is set to 10101010 (which may also be any other value such as 01010101), and the data sampled by the rising edge 4 and the falling edge 5 of the DQS clock signal is checked. When the returned value is "10", the sampled data is considered correct. The DQS clock signal is gradually delayed, and the eye width can be obtained according to the delay where correct data is sampled.
[213] The value of the DCA register corresponding to the 6^{th} phase clock signal is gradually changed until the eye width is maximized. The value of the DCA register when the eye width is maximized is written into the DCA register as the optimal value.
[214] The DQ data is set to 10101010 (which may also be any other value such as 01010101), and the data sampled by the rising edge 6 and the falling edge 7 of the DQS clock signal is checked. When the returned value is "10", the sampled data is considered correct. The DQS clock signal is gradually delayed, and the eye width can be obtained according to the delay where correct data is sampled.
[215] The value of the DCA register corresponding to the 8^{th} phase clock signal is gradually changed until the eye width is maximized. The value of the DCA register when the eye width is maximized is written into the DCA register as the optimal value. Steps [208] to [215] can be performed simultaneously.

In an implementation, the first DCA register group and the second DCA register group may be built into a DDR memory. In this case, the DDR memory may include the first DCA register group, the second DCA register group, and a signal generation unit. The signal generation unit is configured to adjust the phase of a first system clock signal based on the values of the first DCA register group, and generate a DQ data signal of the memory based on the first system clock signal; and adjust the phase of a second system clock signal based on the values of the second DCA register group and generate a DQS clock signal of the memory based on the second system clock signal. That is, by modifying the values of the first DCA register group, the phase relationship between the first system clock signals can be changed, and further, the duration of each phase of the DQ data signal generated by the first system clock signal can be changed. Similarly, by modifying the values of the second DCA register group, the phase relationship between the second system clock signals can be changed, and further, high-level time and low-level time of the DQS clock signal generated by the second system clock signal can be changed.

The above training process may be implemented by a memory controller. Based on the same inventive concept, the embodiments of the present disclosure further provide a memory controller, which may be an internal storage controller. The memory controller is connected to the memory through a DQS clock line and a DQ data line.

In which, the memory controller includes a training engine configured to instruct the adjustment of the values of the first DCA register group and the second DCA register group. When the first DCA register group and the second DCA register group are built into the DDR memory, the training engine is configured to instruct the DDR memory to adjust the values of the first DCA register group to obtain an optimal value of the first DCA register group, so as to optimize the duty cycle distortion of the DQ data signal in the memory, or optimize the clock jitter and the duty cycle distortion of the DQ data signal, or optimize the clock jitter and the duty cycle distortion of the transmission signal of the DDR memory. The values of the first DCA register group are related to the phase of the first system clock signal in the memory, and the first system clock signal is used to generate the DQ data signal. The training engine is further configured to instruct the DDR memory to adjust the values of the second DCA register group based on the optimal value of the first DCA register group obtained by adjustment, so as to obtain an optimal value of the second DCA register group, thereby optimizing the duty cycle distortion of the DQS clock signal in the memory, or optimizing the clock jitter and the duty cycle distortion of the DQS clock signal. The values of the second DCA register group are related to the phase of the second system clock signal in the memory, and the second system clock signal is used to generate the DQS clock signal.

In an implementation, the memory controller further includes a measurement unit configured to obtain an eye width where correct sampled data is obtained by sampling the data transmitted by the DQ data signal (or a new DQ data signal) using the DQS clock signal (or a new DQS clock signal), and obtain a maximum eye width where correct sampled data is obtained by sampling the data transmitted by the DQ data signal (or a new DQ data signal) using the DQS clock signal (or a new DQS clock signal). Correspondingly, the training engine is further configured to instruct the memory to adjust the values of the first DCA register group based on the eye width, and instruct the memory to adjust the values of the second DCA register group based on the maximum eye width.

The training engine is further configured to instruct the DDR memory to adjust the values of the DCA registers corresponding to the first-type phase clock signals in the first DCA register group, so as to optimize the clock jitter of the DQ data signal; and instruct the DDR memory to adjust the values of the DCA registers corresponding to the second-type phase clock signals in the first DCA register group, so as to optimize the duty cycle distortion of the DQ data signal. The training engine is further configured to instruct the DDR memory to adjust the values of the DCA registers corresponding to the first-type phase clock signals in the second DCA register group, so as to optimize the clock jitter of the DQS clock signal; and instruct the DDR memory to adjust the values of the DCA registers corresponding to the second-type phase clock signals in the second DCA register group, so as to optimize the duty cycle distortion of the DQS clock signal.

The training engine may be implemented by various appropriate microprocessors, such as Advanced RISC Machines (ARM)/RISC-V Instruction Set Architecture (RISCV), etc., and the training engine may also be a hardware control circuit. The measurement unit may be a delay calculation circuit, which calculates the eye width by recording the first delay and the second delay.

The principles for adjusting the values of the first DCA register group and the second DCA register group according to the embodiments of the memory controller, as well as the technical effects produced thereby, are the same as those of the embodiments of the aforementioned method. For the sake of brevity, for the parts not mentioned in the embodiments of the memory controller, reference may be made to the corresponding content in the embodiments of the aforementioned method.

The embodiments of the present disclosure further provide an electronic device, which includes a DDR memory and the aforementioned memory controller, wherein the memory controller is connected to the DDR memory through a DQS clock line and a DQ data line. The DDR memory includes a first DCA register group, a second DCA register group, and a signal generation unit. The signal generation unit is configured to adjust the phase of a first system clock signal based on the values of the first DCA register group, and generate a DQ data signal of the memory based on the first system clock signal; and adjust the phase of a second system clock signal based on the values of the second DCA register group, and generate a DQS clock signal of the memory based on the second system clock signal.

In which, the electronic device 200 includes, but is not limited to, a mobile phone, a tablet, a computer, a server, or the like. In an implementation, the structural block diagram of the electronic device may be as illustrated in FIG. 7. The electronic device 200 includes: a transceiver 210, a DDR memory 220, a communication bus 230, and a processor 240. The processor 240 may include a memory controller (e.g., an internal storage controller).

The transceiver 210, the DDR memory 220, and the processor 240 are electrically connected to each other either directly or indirectly to enable data transmission or interaction.

The processor 240 may be an integrated circuit chip with signal processing capabilities. The processor may be a general-purpose processor, including a Central Processing Unit (CPU), a Network Processor (NP), a microprocessor, or the like. The processor may also be a Digital Signal Processor (DSP), an Application Specific Integrated Circuit (ASIC), a Field Programmable Gate Array (FPGA) or any other programmable logic device, a discrete gate or a transistor logic device, or a discrete hardware component. The processor can implement or perform the methods, steps, and logical block diagrams disclosed in the embodiments of the present disclosure. The processor 240 may also be any conventional processor, etc.

It should be noted that various embodiments of the present disclosure are described in a progressive manner, and each of the embodiments focuses on the differences from other embodiments. For the same or similar parts of the embodiments, reference may be made to each other. In addition, functional module in the embodiments of the present disclosure may be integrated together to form an independent part, or each module may exist independently, or two or more modules may be integrated to form an independent part.

Those described above are only specific embodiments of the present disclosure, but the protection scope of the present disclosure is not limited thereto. Any change or substitution easily conceivable by persons skilled in the art within the technical scope disclosed by the present disclosure should fall within the protection scope of the present disclosure. Therefore, the protection scope of the present disclosure shall be subjected to that of the claims.

## Claims

1. A method for optimizing a transmission signal of a memory, comprising:
adjusting the values of a first DCA register group and generating a DQ data signal according to an optimal value of the first DCA register group obtained by adjustment, wherein the values of the first DCA register group are related to a phase of a first system clock signal in the memory, and the first system clock signal is used to generate the DQ data signal; and
adjusting the values of a second DCA register group according to the optimal value of the first DCA register group obtained by adjustment, and generating a DQS clock signal according to the optimal value of the second DCA register group obtained by adjustment, wherein the values of the second DCA register group are related to the phase of a second system clock signal in the memory, and the second system clock signal is used to generate the DQS clock signal; and
wherein the DQS clock signal and the DQ data signal are transmission signals between the memory and a memory controller.

2. The method according to claim 1, wherein the first system clock signal comprises 2ⁿ-phase clock signals each having an independent DCA register, and n is an integer greater than or equal to 2; the adjusting the values of a first DCA register group comprises:
adjusting the values of DCA registers corresponding to first-type phase clock signals in the first DCA register group to obtain an optimal value of the DCA registers corresponding to the first-type phase clock signals, wherein the first-type phase clock signals are those related to the clock jitter of the DQ data signal;
according to the optimal value of the DCA registers corresponding to the first-type phase clock signals obtained by adjustment, adjusting the values of DCA registers corresponding to second-type phase clock signals in the first DCA register group to obtain an optimal value of the DCA registers corresponding to the second-type phase clock signals, wherein the second-type phase clock signals are those related to the duty cycle of the DQ data signal.

3. The method according to claim 1 or 2, wherein the first system clock signal comprises 2ⁿ-phase clock signals each having an independent DCA register, and n is an integer greater than or equal to 2; the adjusting the values of a first DCA register group comprises:
adjusting the values of the first DCA register group and generating the DQ data signal according to the adjusted values of the first DCA register group;
obtaining 2ⁿ eye widths where correct sampled data is obtained by sampling the DQ data signal using the DQS clock signal, wherein each of the eye widths represents a phase difference between a corresponding phase clock signal and a subsequent phase clock signal;
adjusting the values of the first DCA register group according to the 2ⁿ eye widths, so that the 2ⁿ eye widths where correct sampled data is obtained by sampling a new DQ data signal using the DQS clock signal are the same, wherein the new DQ data signal is generated according to the adjusted values of the first DCA register group.

4. The method according to claim 3, wherein the adjusting the values of a first DCA register group according to the 2ⁿ eye widths comprises:
involving n rounds of adjustments of the values of the first DCA register group, wherein a first round of adjustment of the values of the first DCA register group comprises:
based on a sum of the first 2ⁿ⁻¹ eye widths and a sum of the last 2ⁿ⁻¹ eye widths, adjusting the value of the DCA register for a (2ⁿ⁻¹ + 1)-th phase clock signal in the first DCA register group, so that a sum of the first 2ⁿ⁻¹ eye widths is equal to a sum of the last 2ⁿ⁻¹ eye widths;
where i takes values from 2 to n-1 in sequence, an i-th round of adjustment of the values of the first DCA register group comprises:
generating a new DQ data signal according to an optimal value of the first DCA register group obtained from the (i-1)-th round of adjustment, and obtaining 2ⁿ new eye widths according to the new DQ data signal; adjusting the value of the DCA register for an (m*2ⁿ⁻ⁱ + 1)-th phase clock signal in the first DCA register group according to the 2ⁿ new eye widths, so that each sum of eye widths is the same, and each sum of eye widths is a sum of 2ⁿ⁻ⁱ adjacent eye widths, wherein m takes odd numbers in a range [1, 2ⁱ) in sequence;
an n-th round of adjustment of the values of the first DCA register group comprises:
generating a new DQ data signal according to the optimal value of the first DCA register group obtained from the (n-1)-th round of adjustment, and obtaining 2ⁿ new eye widths according to the new DQ data signal; adjusting the value of the DCA register for a (k + 1)-th phase clock signal in the first DCA register group according to the 2ⁿ new eye widths, so that each eye width is the same, wherein k takes odd numbers in a range [1, 2ⁿ) in sequence.

5. The method according to any one of claims 1 to 4, wherein the first system clock signal comprises 2ⁿ-phase clock signals each having an independent DCA register, and n is an integer greater than or equal to 2; the adjusting the values of a first DCA register group comprises:
involving n rounds of adjustments of the values of the first DCA register group, wherein a first round of adjustment of the values of the first DCA register group comprises:
adjusting the values of the DCA register for a (2ⁿ⁻¹ + 1)-th phase clock signal in the first DCA register group according to a first eye width and a second eye width, so that an eye width corresponding to the first 2ⁿ⁻¹ phase clock signals is equal to an eye width corresponding to the last 2ⁿ⁻¹ phase clock signals, wherein the first eye width is an eye width corresponding to the first 2ⁿ⁻¹ phase clock signals, the second eye width is an eye width corresponding to the last 2ⁿ⁻¹ phase clock signals, and each eye width represents a phase difference between a corresponding phase clock signal and a subsequent phase clock signal;
where i takes values from 2 to n-1 in sequence, an i-th round of adjustment of the values of the first DCA register group comprises:
generating a new DQ data signal according to the optimal value of the first DCA register group obtained from the (i-1)-th round of adjustment, and obtaining 2ⁱ eye widths according to the new DQ data signal, wherein each eye width is a sum of the eye widths corresponding to adjacent 2ⁿ⁻ⁱ phase clock signals; and adjusting the value of the DCA register for an (m*2ⁿ⁻ⁱ + 1)-th phase clock signal in the first DCA register group according to 2ⁱ eye widths, so that each eye width is the same, wherein m takes odd numbers in a range [1, 2ⁱ) in sequence;
an n-th round of adjustment of the values of the first DCA register group comprises:
generating a new DQ data signal according to the optimal value of the first DCA register group obtained from the (n-1)-th round of adjustment, and obtaining 2ⁿ eye widths according to the new DQ data signal; and adjusting the value of the DCA register for a (k+1)-th phase clock signal in the first DCA register group according to the 2ⁿ eye widths, so that each adjacent eye width is the same, wherein k takes odd numbers in a range [1, 2ⁿ) in sequence.

6. The method according to any one of claims 1 to 5, wherein the second system clock signal comprises 2ⁿ-phase clock signals each having an independent DCA register, and n is an integer greater than or equal to 2; the adjusting the values of a second DCA register group comprises:
adjusting the values of DCA registers corresponding to first-type phase clock signals in the second DCA register group to obtain an optimal value of the DCA registers corresponding to the first-type phase clock signals, wherein the first-type phase clock signals are those related to the clock jitter of the DQS clock signal;
according to the optimal value of the DCA registers corresponding to the first-type phase clock signals obtained by adjustment, adjusting the values of DCA registers corresponding to second-type phase clock signals in the second DCA register group to obtain an optimal value of the DCA registers corresponding to the second-type phase clock signals, wherein the second-type phase clock signals are those related to the duty cycle of the DQS clock signal.

7. The method according to claim 6, wherein the adjusting the values of DCA registers corresponding to first-type phase clock signals in the second DCA register group comprises:
adjusting the values of DCA registers corresponding to first-type phase clock signals in the second DCA register group, and obtaining a first maximum-width data eye where correct sampled data is obtained by sampling the data transmitted by the DQ data signal using the DQS clock signal; and
taking the value of the DCA register corresponding to the first maximum-width data eye as an optimal value of the DCA registers corresponding to the first-type phase clock signals in the second DCA register group.

8. The method according to claim 7, wherein the adjusting the values of DCA registers corresponding to first-type phase clock signals in the second DCA register group, and obtaining a first maximum-width data eye where correct sampled data is obtained by sampling the data transmitted by the DQ data signal using the DQS clock signal comprises:
involving n-1 rounds of adjustments of the values of the DCA registers corresponding to the first-type phase clock signals in the second DCA register group; wherein
a first round of adjustment of the values of the DCA registers corresponding to the first-type phase clock signals in the second DCA register group comprises:
adjusting the value of the DCA register corresponding to a (2ⁿ⁻¹ + 1)-th phase clock signal multiple times, and obtaining a first maximum-width data eye where correct sampled data is obtained by sampling the data transmitted by the DQ data signal using the DQS clock signal;
where i takes values from 2 to n-1 in sequence, an i-th round of adjustment of the values of the DCA registers corresponding to the first-type phase clock signals in the second DCA register group comprises:
adjusting the value of the DCA register for an (m*2ⁿ⁻ⁱ + 1)-th phase clock signal in the second DCA register group multiple times according to the optimal value of the second DCA register group obtained from the (i-1)-th round of adjustment, and obtaining a first maximum-width data eye where correct sampled data is obtained by sampling the data transmitted by the DQ data signal using the DQS clock signal, wherein m takes odd numbers in a range [1, 2ⁱ) in sequence.

9. The method according to claim 6, wherein the adjusting the values of DCA registers corresponding to second-type phase clock signals in the second DCA register group according to the optimal value of the DCA registers corresponding to the first-type phase clock signals obtained by adjustment comprises:
generating a new DQS clock signal according to the optimal value of the DCA registers corresponding to the first-type phase clock signals obtained by adjustment;
adjusting the values of DCA registers corresponding to second-type phase clock signals, and obtaining a second maximum-width data eye where correct sampled data is obtained by sampling the data transmitted by the DQ data signal using the new DQS clock signal;
taking the value of the DCA register corresponding to the second maximum-width data eye as an optimal value of the DCA registers corresponding to the second-type phase clock signals.

10. The method according to claim 9, wherein the adjusting the values of DCA registers corresponding to second-type phase clock signals, and obtaining a second maximum-width data eye where correct sampled data is obtained by sampling the data transmitted by the DQ data signal using the new DQS clock signal comprises:
adjusting the value of the DCA register for a (k+1)-th phase clock signal in the second DCA register group multiple times, and obtaining a second eye width where correct sampled data is obtained by sampling the data transmitted by the DQ data signal using the new DQS clock signal, wherein k takes odd numbers in a range [1, 2ⁿ) in sequence.

11. A memory controller connected to a memory through a DQS clock line and a DQ data line, wherein the DQS clock line is configured to transmit a DQS clock signal, the DQ data line is configured to transmit a DQ data signal, and the memory controller comprises:
a training engine configured to instruct the memory to adjust the values of the first DCA register group to obtain an optimal value of the first DCA register group, wherein the values of the first DCA register group are related to the phase of a first system clock signal in the memory, and the first system clock signal is used to generate the DQ data signal;
the training engine is further configured to,
instruct the memory to adjust the values of the second DCA register group according to the optimal value of the first DCA register group obtained by adjustment, so as to obtain an optimal value of the second DCA register group, wherein the values of the second DCA register group are related to the phase of a second system clock signal in the memory, and the second system clock signal is used to generate the DQS clock signal.

12. The memory controller according to claim 11, further comprising:
a measurement unit configured to obtain an eye width where correct sampled data is obtained by sampling the data transmitted by the DQ data signal using the DQS clock signal, and obtain a maximum eye width where correct sampled data is obtained by sampling the data transmitted by the DQ data signal using the DQS clock signal;
the training engine is further configured to instruct the memory to adjust the values of the first DCA register group according to the eye width, and instruct the memory to adjust the values of the second DCA register group according to the maximum eye width.

13. An electronic device, comprising:
a memory and the memory controller according to claim 11 or 12, wherein the memory controller is connected to the memory through a DQS clock line and a DQ data line, the DQS clock line is configured to transmit a DQS clock signal, and the DQ data line is configured to transmit a DQ data signal;
the memory comprises a first DCA register group, a second DCA register group, and a signal generation unit,
the signal generation unit is configured to adjust the phase of a first system clock signal according to the values of the first DCA register group and generate the DQ data signal according to the first system clock signal, and adjust the phase of a second system clock signal according to the values of the second DCA register group and generate the DQS clock signal according to the second system clock signal.
